# EUROPEAN PATENT APPLICATION

(11) **EP 4 766 144 A1**
(43) Date of publication of application: **24.06.2026**
(21) Application number: 25209538.5
(22) Date of filing: 17.10.2025
(51) Int. Cl.: H10W 70/692, H10W 70/63

(54) **BOTTOM-UP PLATING OF THROUGH-GLASS VIAS**

(30) Priority: 18.12.2024 US 202418985261
(71) Applicant: Intel Corporation, Santa Clara, CA 95054 (US)
(72) Inventor: RAHMAN, Mohammad Mamunur, Chandler, AZ 85249 (US); PIETAMBARAM, Srinivas Venkata Ramanuja, Chandler, AZ 95249 (US); KANDANUR, Sashi Shekhar, Chandler, AZ 85226 (US)
(74) Representative: HGF

(57) **Abstract**

Various techniques, as well as related devices and methods, for performing metallization of through-glass vias (TGVs) in glass substrates using bottom-up plating are disclosed. A first technique is based on using subtractive etch. A second technique is based on using modified semi-additive process. A third technique is based on using flowable materials to fill a cavity in a glass substrate alongside performing bottom-up plating. Any of these techniques may further be modified by including a liner on sidewalls of TGVs to serve as a buffer layer between the glass substrate and conductive material(s) in the TGVs.

## Description

### Background

For the past several decades, scaling of features in integrated circuits (ICs) has been a driving force behind an ever-growing semiconductor industry and emerging applications in fields such as big data, artificial intelligence, mobile communications, and autonomous driving. Parallel to optimizations at the IC level, advanced semiconductor packaging landscape is rapidly evolving to accommodate performance expectations and requirements of shrinking dimensions of IC features. Multiple IC dies are now commonly coupled together in a multi-die semiconductor package to integrate features or functionality and to facilitate connections to other components, such as package substrates. For example, IC packages may include an embedded multi-die interconnect bridge (EMIB) for coupling two or more IC dies.

Integration of multiple dies in a single IC package has tremendous benefits but adds additional complexities due to placing materials with different material properties in close proximity to one another. When an IC package undergoes multiple processing steps involving various temperatures and pressure loads, individual materials within the package may behave differently from one another, resulting in out of plane deformation of various layers, known as "package warpage." One way to address package warpage is to use stiffer cores to which different IC dies are attached. Recently, glass substrates have been explored as alternatives to organic resin-based cores (e.g., cores based on using Ajinomoto Build-up Film (ABF)). Glass is considered more rigid than organic resin-based materials and has several advantages such as excellent thermal properties, low coefficient of thermal expansion (CTE), high electrical insulation, chemical resistance, optical transparency, and compatibility with advances semiconductor properties.

The advantageous properties of glass makes it valuable not only for use as cores in semiconductor/IC packages but also for a variety of other roles. For example, glass substrates offer high mechanical stability, precise flatness, and smooth surfaces, which are ideal for the dense interconnects and redistribution layers (RDLs) used in advanced IC packages. In another example, glass's stability and low CTE are particularly advantageous for embedding of passive components, e.g., capacitors and inductors, directly within the substrate, which improves circuit density and simplifies the layout, reducing the need for additional external components. In yet another example, the low dielectric constant and dielectric loss of glass make it highly suitable for applications that require minimal signal attenuation and interference, such as radio frequency (RF) and 5G communications, where glass substrates may serve as base layers for RF modules and antennas, enabling high-frequency performance with reduced signal loss. Furthermore, glass is optically transparent, enabling efficient light transmission, which is a distinct advantage over silicon and organic substrates for optical and photonic applications where glass substrates may be well-suited for housing optoelectronic components, such as photonic integrated circuits (PICs), image sensors, and light-emitting diodes (LEDs).

For many applications of glass substrates in IC packaging, through-glass vias (TGVs) filled with metals are essential. TGVs are conductive vertical channels that pass through the glass substrate, enabling electrical connections from one side of the substrate to the other or from one side of the substrate to a component embedded within the substrate. Achieving cost-efficient and high-performance metallization of TGVs (i.e., filling the TGVs with conductive materials such as metals) remains a major technical challenge, and further advancements are critical for the broader adoption of glass substrates in IC packaging.

### Brief Description of the Drawings

Embodiments will be readily understood by the following detailed description in conjunction with the accompanying drawings. To facilitate this description, like reference numerals designate like structural elements. Embodiments are illustrated by way of example, not by way of limitation, in the figures of the accompanying drawings.
FIG. 1 is a schematic side, cross-sectional view of one example microelectronic assembly in which a glass substrate having TGVs fabricated using bottom-up plating techniques as described herein may be implemented, according to some embodiments of the present disclosure.
FIG. 2 is a schematic side, cross-sectional view of another example microelectronic assembly in which a glass substrate having TGVs fabricated using bottom-up plating techniques as described herein may be implemented, according to some embodiments of the present disclosure.
FIG. 3 illustrates surfaces of a glass core from which TGV stress may initiate.
FIGS. 4A-4F provide schematic illustrations of cross-sectional side views of microelectronic assemblies with an example glass substrate at various stages in the fabrication of TGVs formed by bottom-up plating using subtractive etching, according to some embodiments of the present disclosure.
FIGS. 5A-5C provide schematic illustrations of cross-sectional side views of portions of example glass substrates showing features indicative of the use of the fabrication method of FIGS. 4A-4F, according to some embodiments of the present disclosure.
FIGS. 6A-6K provide schematic illustrations of cross-sectional side views of microelectronic assemblies with an example glass substrate at various stages in the fabrication of TGVs formed by bottom-up plating using modified semi-additive process, according to some embodiments of the present disclosure.
FIGS. 7A-7D provide schematic illustrations of cross-sectional side views of example glass substrates showing features indicative of the use of the fabrication method of FIGS. 6A-6K, according to some embodiments of the present disclosure.
FIGS. 8A-8H provide schematic illustrations of cross-sectional side views of microelectronic assemblies with an example glass substrate at various stages in the fabrication of TGVs formed by bottom-up plating with flowable cavity-fill materials, according to some embodiments of the present disclosure.
FIGS. 9A-9B provide schematic illustrations of cross-sectional side views of example glass substrates showing features indicative of the use of the fabrication method of FIGS. 8A-8H, according to some embodiments of the present disclosure.
FIGS. 10A-10H provide schematic illustrations of cross-sectional side views of microelectronic assemblies with an example glass substrate at various stages in the fabrication of TGVs formed by bottom-up plating using subtractive etching in combination with the use of a liner, according to some embodiments of the present disclosure.
FIGS. 11A-11M provide schematic illustrations of cross-sectional side views of microelectronic assemblies with an example glass substrate at various stages in the fabrication of TGVs formed by bottom-up plating using modified semi-additive process in combination with the use of a liner, according to some embodiments of the present disclosure.
FIGS. 12A-12J provide schematic illustrations of cross-sectional side views of microelectronic assemblies with an example glass substrate at various stages in the fabrication of TGVs formed by bottom-up plating with flowable cavity-fill materials in combination with the use of a liner, according to some embodiments of the present disclosure.
FIG. 13 is a top view of a wafer and dies that may be included in a microelectronic assembly with a glass core in accordance with any of the embodiments disclosed herein, according to some embodiments of the present disclosure.
FIG. 14 is a side, cross-sectional view of an IC device that may be included in a microelectronic assembly with a glass core in accordance with any of the embodiments disclosed herein, according to some embodiments of the present disclosure.
FIG. 15 is a side, cross-sectional view of an IC device assembly that may include a glass core in accordance with any of the embodiments disclosed herein, according to some embodiments of the present disclosure.
FIG. 16 is a block diagram of an example communication device that may include a microelectronic assembly with a glass core in accordance with any of the embodiments disclosed herein, according to some embodiments of the present disclosure.

### Detailed Description

As mentioned above, glass has properties that make it promising for integration in advanced IC packaging. When a glass substrate is included in a microelectronic assembly, it may be desirable to route electrical signals in and/or through the glass substrate. To that end, conductive vias may be provided in the glass substrate, such conductive vias commonly referred to as "TGVs." TGVs may also support efficient thermal management by providing paths for heat dissipation from the active components to the package's external environment. In some implementations, TGVs may extend between the top and the bottom surfaces of a glass substrate, e.g., to provide electrical connectivity between electronic components such as dies and/or package substrates, coupled to the top and bottom surfaces of the glass substrate. In other implementations, TGVs may be blind vias that extend from the top/bottom surface of the glass substrate towards, but not reaching, the opposite surface, e.g., to provide electrical connectivity from a surface of the glass substrate to a conductive trace or a passive component embedded in the glass substrate.

One challenge associated with integration of TGVs in glass substrates arises from the differences in CTEs between materials that may be used for glass substrates and conductive materials/metals (e.g., of conductive fill materials and/or seed materials) deposited in the TGVs. CTE is a measure of how a material expands or contracts with changes in temperature and is typically defined as the fractional increase in length per unit rise in temperature, measured in, e.g., parts per million (ppm) per degrees Kelvin (K) or ppm/K. Metals and glass materials have significantly different CTEs. Metals have relatively high CTEs, meaning that they may expand and contract significantly with changes in temperature. Glass materials, on the other hand, have much lower CTEs and are less responsive to temperature changes. For example, a CTE of glass is on the order of about 3.5 ppm/K, while a CTE of a metal such as copper is on the order of about 15 ppm/K. When a metal is in close contact with glass (e.g., a seed material or a conductive fill material within a TGV in the glass substrate), and the assembly is exposed to temperature variations such as heating or cooling, the metal will heat up or cool down much faster, and to a greater extent, than the glass. This leads to the generation of significant thermal stress at the interface between the two materials. The high thermal stress can exceed the strength of the glass, leading to the formation of cracks, which may then propagate and compromise the structural integrity of the glass. Even if cracks don't form immediately, the repeated thermal cycling can gradually weaken the glass surface, potentially leading to the development of surface flaws or micro-cracks. Prolonged exposure to CTE mismatch-induced stresses can cause gradual degradation of the glass, making it more prone to failure over time. CTE mismatch-induced stresses caused by the proximity of conductive materials of TGVs to glass materials of the glass substrates are referred to as "TGV stresses."

Embodiments of the present disclosure relate to various techniques, as well as to related devices and methods, for performing metallization of TGVs in glass substrates using bottom-up plating in ways that may be both cost-efficient and meet performance standards. A first technique is based on using subtractive etch (SE) and may, therefore, be referred to as "bottom-up plating using SE." A second technique is based on using modified semi-additive process (mSAP) and may, therefore, be referred to as "bottom-up plating using mSAP." A third technique is based on using flowable materials to fill a cavity in a glass substrate alongside performing bottom-up plating and may, therefore, be referred to as "bottom-up plating with flowable cavity-fill materials." All three techniques rely on performing bottom-up plating without using a layer of a seed material on sidewalls of TGV openings prior to filling the TGV openings with conductive materials, which is in sharp contrast to many conventional techniques for TGV metallization. As a result, air gaps may inevitably form between the sidewalls of TGV openings and conductive materials within the TGV openings. Such air gaps separate the glass substrate and conductive materials in the TGVs and may, therefore, help alleviate (e.g., mitigate or reduce) CTE mismatch-induced stresses caused by the proximity of conductive materials of TGVs to glass materials of the glass substrates (i.e., may help alleviate TGV stresses). In addition, air gaps may advantageously provide space for thermal expansion of the conductive materials in the TGVs without such expansion affecting sidewalls of the TGV openings. Furthermore, bottom-up plating techniques described herein may be more cost-efficient than conventional approaches to TGV metallization because they may allow eliminating one or more processing steps, such as planarization or using a seed material on sidewalls of TGV openings.

Any of the bottom-up plating techniques disclosed herein may further be modified by including a liner on sidewalls of TGVs to serve as a buffer layer between the glass substrate and conductive material(s) in the TGVs, which may further help with alleviating TGV stresses because the liner further separates (e.g., in addition to the air gaps formed by the bottom-up plating withouta seed material on sidewalls) the glass and metals deposited in the TGVs. In some embodiments, using a liner having a relatively low modulus, e.g., having Young's modulus below about 30 gigapascal (GPa), may be particularly advantageous for reducing TGV stress because it may help with reducing compressive stresses caused by, e.g., expansion of the metals subsequently filled into the TGV. In some embodiments, using a liner having a CTE lower than that of the metals in the TGVs may reduce the CTE mismatch at the interface with the glass, which may help reduce TGV stresses. In some embodiments, the liner may act as a stress-absorbing layer. In some embodiments, the liner may include an organic material such as parylene, where the name "parylene" refers to a group of polymers known as poly-para-xylylenes. In some embodiments, any of the bottom-up plating techniques disclosed herein may be modified by including multiple liners on sidewalls of TGVs prior to metallization, where different liners may serve different purposes aiming to reduce TGV stresses.

Integration of layers of different materials (e.g., multiple dies, redistribution layers, package substrates) in a single IC package or a microelectronic assembly is challenging due to package warpage, among others. Providing IC packages or microelectronic assemblies with glass substrates having TGVs fabricated using bottom-up plating techniques as described herein may help. Various ones of the embodiments disclosed herein may help achieve reliable integration of multiple layers of different materials within a single microelectronic assembly at a lower cost and/or with greater design flexibility, relative to conventional approaches. Various ones of the microelectronic assemblies disclosed herein may exhibit reduced warpage, relative to microelectronic assemblies without glass substrates. The microelectronic assemblies disclosed herein may be particularly advantageous for small and low-profile applications in computers, tablets, industrial robots, and consumer electronics (e.g., wearable devices).

In the following detailed description, reference is made to the accompanying drawings that form a part hereof wherein like numerals designate like parts throughout, and in which is shown, by way of illustration, embodiments that may be practiced. It is to be understood that other embodiments may be utilized, and structural or logical changes may be made, without departing from the scope of the present disclosure. Therefore, the following detailed description is not to be taken in a limiting sense.

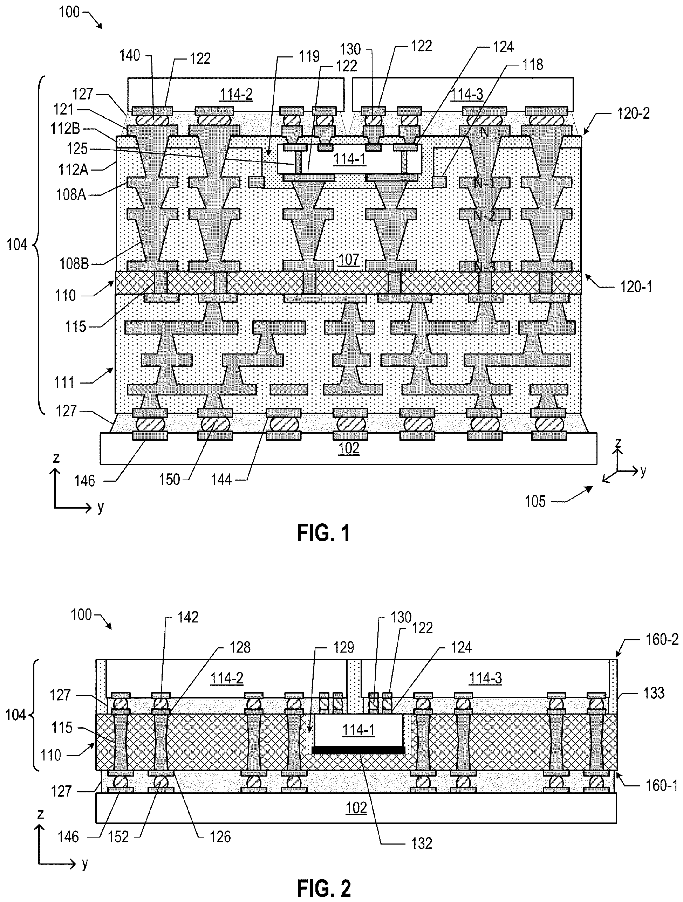

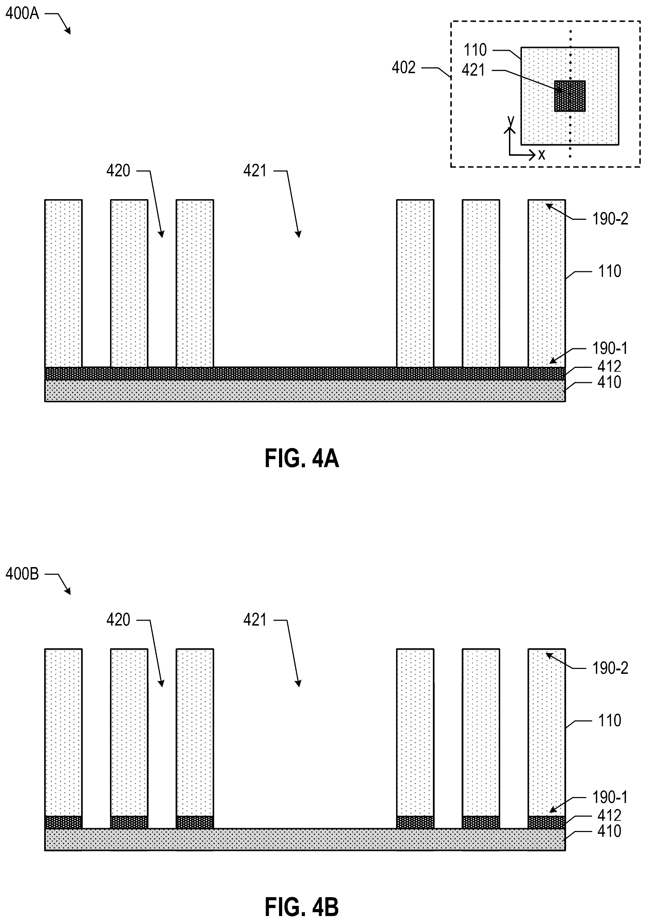

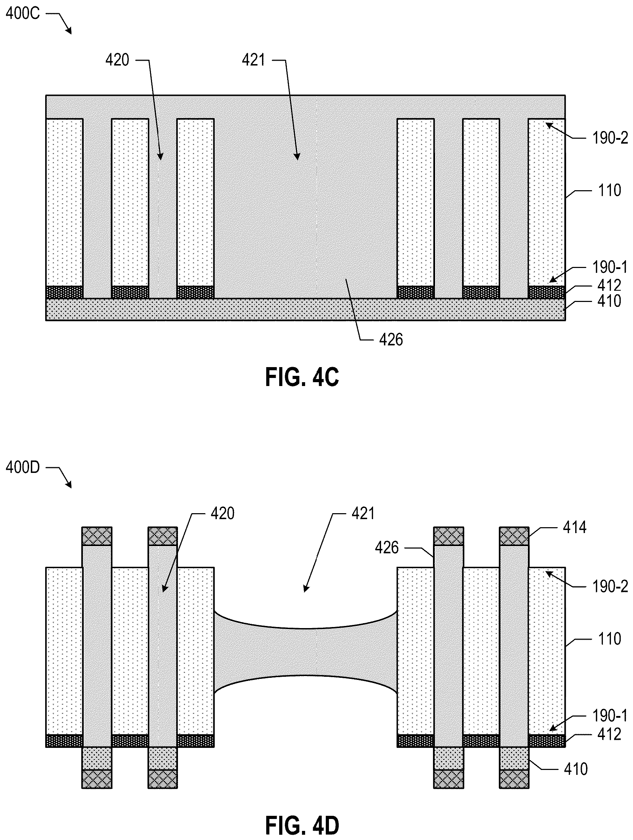

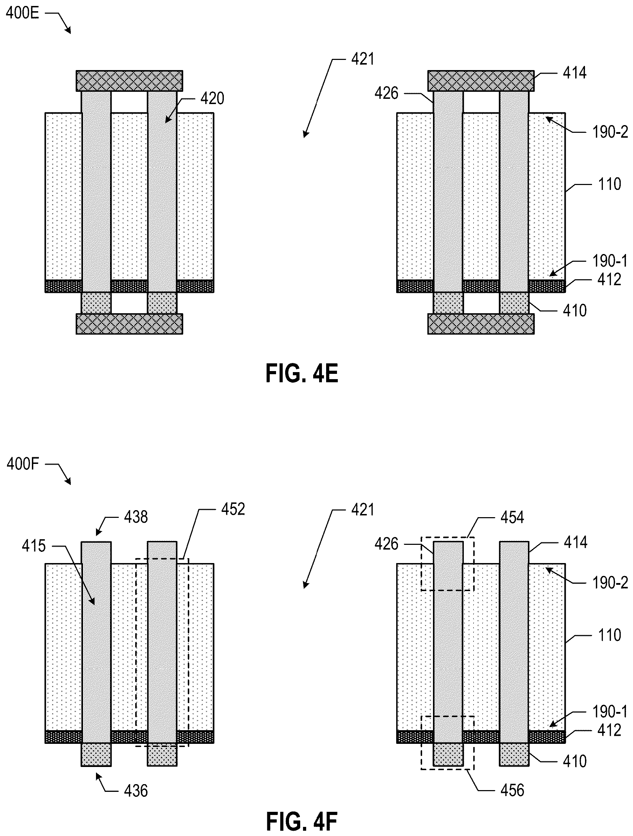

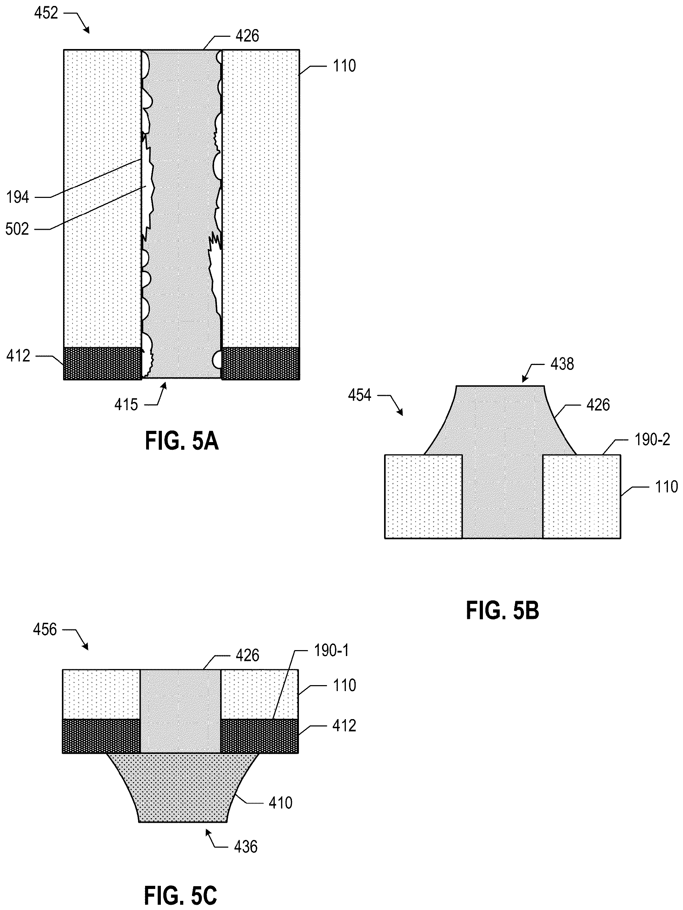

Any of the features discussed with reference to any of accompanying drawings herein may be combined with any other features to form a microelectronic assembly 100, a glass substrate 110, an IC device 1600, an IC device assembly 1700, or a communication device 1800, as appropriate. For convenience, the phrase "dies 114" may be used to refer to a collection of dies 114-1, 114-2, and so on, etc. A number of elements of the drawings with same reference numerals may be shared between different drawings; for ease of discussion, a description of these elements provided with respect to one of the drawings is not repeated for the other drawings, and these elements may take the form of any of the embodiments disclosed herein. To not clutter the drawings, if multiple instances of certain elements are illustrated, only some of the elements may be labeled with a reference numeral (e.g., a plurality of conductive contacts 122 are shown in FIG. 1 but only one of the them is labeled with a reference numeral). Also to not clutter the drawings, not all reference numerals shown in one of the drawings are shown in other similar drawings. Furthermore, a plurality of drawings labeled with different letters may be referred to without a letter, e.g., FIGS. 4A-4F maybe referred to as "FIG. 4," FIGS. 5A-5C may be referred to as "FIG. 5," and so on.

The drawings are not necessarily to scale. Although many of the drawings illustrate rectilinear structures with flat walls and right-angle corners, this is simply for ease of illustration and may not reflect real-life process limitations which may cause various features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers. There may be other defects not listed here but that are common within the field of semiconductor device fabrication and packaging. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of glass substrates having TGVs fabricated using bottom-up plating techniques as described herein as described herein.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). When used to describe a range of dimensions, the phrase "between X and Y" represents a range that includes X and Y. When used to describe a location of an element, the phrase "between X and Y" represents a region that is spatially between element X and element Y. The terms "substantially," "close," "approximately," "near," and "about," generally refer to being within +/-20%, e.g., within +/- 5% or within +/- 2%, of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 10%, e.g., within +/- 5% or within +/- 2%, of the exact orientation.

The description uses the phrases "in an embodiment" or "in embodiments," which may each refer to one or more of the same or different embodiments. Furthermore, the terms "comprising," "including," "having," and the like, as used with respect to embodiments of the present disclosure, are synonymous. As used herein, the terms "package" and "IC package" are synonymous, as are the terms "die" and "IC die." Furthermore, the terms "chip," "chiplet," "die," and "IC die" may be used interchangeably herein.

Although certain elements may be referred to in the singular herein, such elements may include multiple sub-elements. For example, "a dielectric material" may include one or more dielectric materials or "an insulator material" may include one or more insulator materials. The terms "oxide," "carbide," "nitride," etc. refer to compounds containing, respectively, oxygen, carbon, nitrogen, etc. The term "high-k dielectric" refers to a material having a higher dielectric constant than silicon oxide, while the term "low-k dielectric" refers to a material having a lower dielectric constant than silicon oxide. The term "insulating" and variations thereof (e.g., "insulative" or "insulator") means "electrically insulating," the term "conducting" and variations thereof (e.g., "conductive" or "conductor") means "electrically conducting," unless otherwise specified. With reference to optical signals and/or devices, components and elements that operate on or using optical signals, the term "conducting" can also mean "optically conducting." The term "insulating material" refers to solid materials (and/or liquid materials that solidify after processing as described herein) that are substantially electrically nonconducting. They may include, as examples and not as limitations, organic polymers and plastics, and inorganic materials such as ionic crystals, porcelain, glass, silicon and alumina or a combination thereof. They may include dielectric materials, high polarizability materials, and/or piezoelectric materials. They may be transparent or opaque without departing from the scope of the present disclosure. Further examples of insulating materials are underfills and molds or mold-like materials used in packaging applications, including for example, materials used in organic interposers, package supports and other such components.

FIG. 1 is a schematic side, cross-sectional view of one example microelectronic assembly 100 in which a glass substrate having TGVs fabricated using bottom-up plating techniques as described herein may be implemented, according to some embodiments of the present disclosure. The microelectronic assembly 100 may include a substrate 107 with a double-sided bridge die 114-1 in a cavity 119 in the substrate 107, the die 114-1 may be electrically coupled to a conductive pathway, e.g., a conductive trace 108A or a conductive via 108B, in a metal layer N-1 of the substrate 107 that is beneath a bottom of the cavity 119. The substrate 107 may include a dielectric material 112 (e.g., a first dielectric material layer 112A and a second dielectric material layer 112B, as shown, together referred to as "one or more layers of the dielectric material 112") and a conductive material 108 arranged in the one or more layers of the dielectric material 112 to provide conductive pathways (e.g., conductive traces 108A and conductive vias 108B) through the substrate 107, as well as to provide conductive pads and contacts. The substrate 107 may include a first surface 120-1 and an opposing second surface 120-2. The die 114-1 may be surrounded by the dielectric material 112 of the substrate 107. The die 114-1 may include a bottom face (e.g., the surface facing towards the first surface 120-1) with first conductive contacts 122, an opposing top face (e.g., the surface facing towards the second surface 120-2) with second conductive contacts 124, and through-silicon vias (TSVs) 125 coupling respective first and second conductive contacts 122, 124. In some embodiments, a pitch of the first conductive contacts 122 on the first die 114-1 maybe between 25 microns and 250 microns. As used herein, pitch is measured center-to-center (e.g., from a center of a conductive contact to a center of an adjacent conductive contact). In some embodiments, a pitch of the second conductive contacts 124 on the first die 114-1 maybe between 25 microns and 100 microns. The dies 114-2, 114-3 may include a set of conductive contacts 122 on the bottom face of the die (e.g., the surface facing towards the first surface 120-1). The die 114 may include other conductive pathways (e.g., including lines and vias) and/or to other circuitry (not shown) coupled to the respective conductive contacts (e.g., conductive contacts 122, 124) on the surface of the die 114. As used herein, the terms "die," "microelectronic component," and similar variations may be used interchangeably. As used herein, the terms "interconnect component," "bridge die," and similar variations may be used interchangeably. The bridge die 114-1 may be electrically coupled to dies 114-2, 114-3 by die-to-die (DTD) interconnects 130 at a second surface 120-2. In particular, conductive contacts 124 on a top face of the die 114-1 may be coupled to conductive contacts 122 on a bottom face of dies 114-2, 114-3 by conductive vias 108B through the second dielectric material layer 112B.

As used herein, a "conductive contact" may refer to a portion of conductive material (e.g., metal) serving as an electrical interface between different components (e.g., part of a conductive interconnect); conductive contacts may be recessed in, flush with, or extending away (e.g., having a pillar shape) from a surface of a component, and may take any suitable form (e.g., a conductive pad or socket, or portion of a conductive line or via). In a general sense, an "interconnect" refers to any element that provides a physical connection between two other elements. For example, an electrical interconnect provides electrical connectivity between two electrical components, facilitating communication of electrical signals between them; an optical interconnect provides optical connectivity between two optical components, facilitating communication of optical signals between them. As used herein, both electrical interconnects and optical interconnects are comprised in the term "interconnect." The nature of the interconnect being described is to be understood herein with reference to the signal medium associated therewith. Thus, when used with reference to an electronic device, such as an IC that operates using electrical signals, the term "interconnect" describes any element formed of a conductive material for providing electrical connectivity to one or more elements associated with the IC or/and between various such elements. In such cases, the term "interconnect" may refer to both conductive traces (also sometimes referred to as "metal traces," "lines," "metal lines," "wires," "metal wires," "trenches," or "metal trenches") and conductive vias (also sometimes referred to as "vias" or "metal vias"). Sometimes, conductive traces and vias may be referred to as "metal traces" and "metal vias", respectively, to highlight the fact that these elements include conductive materials such as metals. Likewise, when used with reference to a device that operates on optical signals as well, such as a photonic IC (PIC), "interconnect" may also describe any element formed of a material that is optically conductive for providing optical connectivity to one or more elements associated with the PIC. In such cases, the term "interconnect" may refer to optical waveguides (e.g., structures that guide and confine light waves), including optical fiber, optical splitters, optical combiners, optical couplers, and optical vias.

The die 114 disclosed herein may include an insulating material (e.g., a dielectric material formed in multiple layers, as known in the art) and multiple conductive pathways formed through the insulating material. In some embodiments, the insulating material of a die 114 may include a dielectric material, such as silicon dioxide, silicon nitride, oxynitride, polyimide materials, glass reinforced epoxy matrix materials, or a low-k or ultra low-k dielectric (e.g., carbon-doped dielectrics, fluorine-doped dielectrics, porous dielectrics, organic polymeric dielectrics, photo-imageable dielectrics, and/or benzocyclobutene-based polymers). In some embodiments, the insulating material of a die 114 may include a semiconductor material, such as silicon, germanium, or a III-V material (e.g., gallium nitride), and one or more additional materials. For example, an insulating material may include silicon oxide or silicon nitride. The conductive pathways in a die 114 may include conductive traces and/or conductive vias, and may connect any of the conductive contacts in the die 114 in any suitable manner (e.g., connecting multiple conductive contacts on a same surface or on different surfaces of the die 114). Example structures that may be included in the dies 114 disclosed herein are discussed below with reference to the IC device 1600. The conductive pathways in the dies 114 may be bordered by liners, such as adhesion liners and/or barrier liners, as suitable. In some embodiments, the die 114 is a wafer. In some embodiments, the die 114 is a monolithic silicon, a fan-out or fan-in package die, or a die stack (e.g., wafer stacked, die stacked, or multi-layer die stacked).

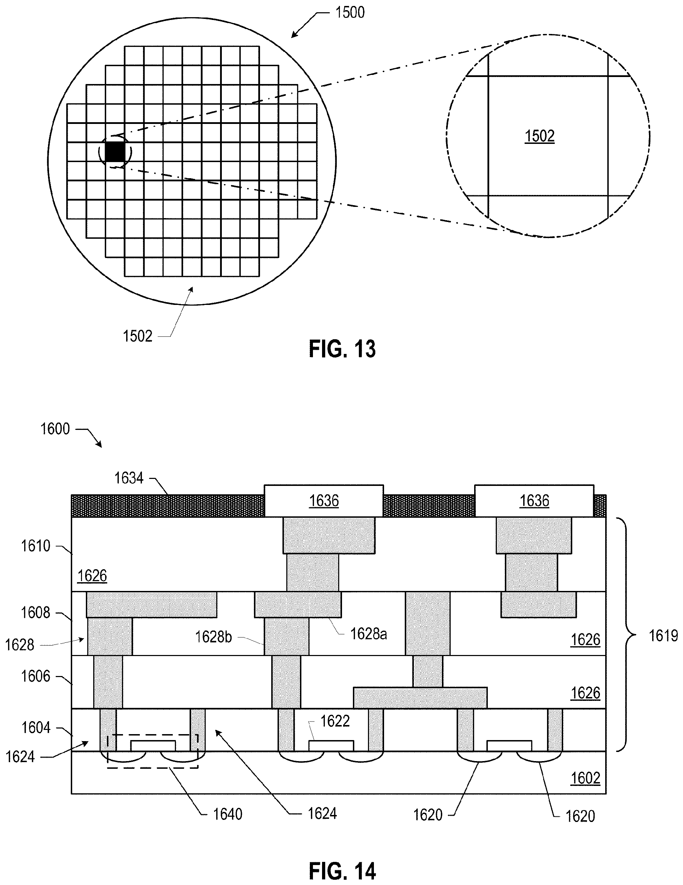

In some embodiments, the die 114 may include conductive pathways to route power, ground, and/or signals to/from other dies 114 included in the microelectronic assembly 100. For example, the die 114-1 may include TSVs 125, including a conductive via, such as a metal via, isolated from the surrounding silicon or other semiconductor material by a barrier oxide),or other conductive pathways through which power, ground, and/or signals may be transmitted between the package substrate 102 and one or more dies 114 "on top" of the die 114-1 (e.g., in the embodiment of FIG. 1, the dies 114-2 and/or 114-3). In some embodiments, the die 114-1 may not route power and/or ground to the dies 114-2 and 114-3; instead, the dies 114-2, 114-3 may couple directly to power and/or ground lines in the package substrate 102 by substrate-to-package substrate (STPS) interconnects 150, conductive pathways provided by the conductive material 108 in the substrate 107 and die-to-substrate (DTS) interconnects 140. In some embodiments, the die 114-1 may be thicker than the dies 114-2, 114-3. In some embodiments, the die 114-1 may be a memory device or a high-frequency serializer and deserializer (SerDes), such as a Peripheral Component Interconnect (PCI) express. In some embodiments, the die 114-1 may be a processing die, an RF chip, a power converter, a network processor, a workload accelerator, a voltage regulator die, or a security encryptor. In some embodiments, the die 114-2 and/or the die 114-3 may be a processing die, an RF chip, a power converter, a network processor, a workload accelerator, a voltage regulator die, or a security encryptor. In some embodiments, the die 114 may be as described below with reference to the die 1502 of FIG. 13.

The dielectric material 112 of the substrate 107 may be formed in layers (e.g., at least a first dielectric material layer 112A and a second dielectric material layer 112B). In some embodiments, the dielectric material 112 may include an organic material, such as an organic build-up film. In some embodiments, the dielectric material 112 may include a ceramic, an epoxy film having filler particles therein, glass, an inorganic material, or combinations of organic and inorganic materials, for example. In some embodiments, the conductive material 108 may include a metal (e.g., copper). In some embodiments, the substrate 107 may include layers of dielectric material 112/conductive material 108, with lines/traces/pads/contacts (e.g., conductive traces 108A) of conductive material 108 in one layer electrically coupled to lines/traces/pads/contacts (e.g., conductive traces 108A) of conductive material 108 in an adjacent layer by vias (e.g., 108B) of the conductive material 108 extending through the dielectric material 112. Conductive traces 108A may be referred to herein as "conductive lines," "conductive elements," "conductive pads," or "conductive contacts." A substrate 107 including such layers may be formed using a printed circuit board (PCB) fabrication technique, for example.

An individual layer of dielectric material 112 (e.g., a first dielectric material layer 112A) may include a cavity 119 and the bridge die 114-1 may be at least partially nested in the cavity 119. The bridge die 114-1 may be surrounded by (e.g., embedded in) a next individual layer of dielectric material 112 (e.g., a second dielectric material layer 112B). In some embodiments, a cavity 119 is tapered, narrowing towards a bottom face of the cavity 119 (e.g., the surface towards the first surface 120-1 of the substrate 107). A cavity 119 may be indicated by a seam between the dielectric material 112A and the dielectric material 112B. As shown in FIG. 1, in cases where the bridge die 114-1 is partially nested in a cavity 119, a top face of the bridge die 114-1 may extend above a top face of dielectric material 112A. In cases where the bridge die 114-1 is fully nested in a cavity 119 (not shown), a top face of the bridge die 114-1 may be planar with or below a top face of dielectric material 112A.

A substrate 107 may include N layers of conductive material 108, where N is an integer greater than or equal to one. In FIG. 1, the layers are labeled in descending order from the second surface 120-2 (e.g., the top face) of the substrate 107 (e.g., layer N, layer N-1, layer N-2, etc.). In particular, as shown in FIG. 1, a substrate 107 may include four metal layers (e.g., N, N-1, N-2, and N-3). The N metal layer may include conductive contacts 121 at the second surface 120-2 of the substrate 107 that are coupled to conductive contacts 122 at bottom faces of the die 114-2, 114-3 by DTS interconnects 140. The N-2 metal layer may include conductive traces 108A having a top face (e.g., the surface facing towards the second surface 120-2 of the substrate 107), an opposing bottom face (e.g., the surface facing towards the first surface 120-1 of the substrate 107), and lateral surfaces extending between the top and bottom faces of the conductive traces 108A. A substrate 107 may further include an N-1 metal layer above the N-2 metal layer and below the N metal layer, where a portion of the N-1 metal layer includes a metal ring 118 exposed at a perimeter of the bottom of the cavity 119. The metal ring 118 may be coplanar with the conductive traces 108A of the N-1 metal layer and may be proximate to the edges of the cavity 119, as shown.

Although a particular number and arrangement of layers of dielectric material 112/conductive material 108 are shown in various ones of the accompanying figures, these particular numbers and arrangements are simply illustrative, and any desired number and arrangement of dielectric material 112/conductive material 108 may be used. Further, although a particular number of layers are shown in the substrate 107 (e.g., four layers), these layers may represent only a portion of the substrate 107, for example, further layers may be present (e.g., layers N-4, N-5, N-6, etc.).

As shown in FIG. 1, the substrate 107 may further include a glass substrate 110 with TGVs 115 and further layers 111 may be present below the glass substrate 110 and coupled to a package substrate 102 by interconnects 150. Any of the TGVs 115 may be a conductive via fabricated using bottom-up plating techniques as described herein. As used herein, the term "glass substrate" refers to a layer (e.g., a glass layer) or a structure (e.g., a portion of a glass layer) of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass. In particular, the glass substrate 110 may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass substrate 110 may be an amorphous solid glass layer. In some embodiments, the glass substrate 110 may include a material comprising silicon and oxygen, as well as any one or more of aluminum, boron, magnesium, calcium, barium, tin, sodium, potassium, strontium, phosphorus, zirconium, lithium, titanium, and zinc. In some embodiments, the glass substrate 110 may include a material, e.g., any of the materials described above, with a weight percentage of silicon being at least about 0.5%, e.g., between about 0.5% and 50%, between about 1% and 48%, or at least about 23%. For example, if the glass substrate 110 is fused silica, the weight percentage of silicon may be about 47%. In some embodiments, the glass substrate 110 may include a material having at least 23% silicon and/or at least 26% oxygen by weight, and, in some further embodiments, the glass substrate 110 may further include at least 5% aluminum by weight. In some embodiments, the glass substrate 110 may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn. In some embodiments, the glass substrate 110 may be a layer of glass that does not include an organic adhesive or an organic material. The glass substrate 110 may be distinguished from, for example, the "prepreg" or "RF4" core of a PCB substrate which typically includes glass fibers embedded in a resinous organic material such as an epoxy. In such traditional cores/substrates including glass fibers and epoxy, the diameter of the glass fibers is generally in the range of 5 micron to 200 micron. In contrast, the glass substrate 110 may be a layer of glass that is about 10 millimeters on a side to about 250 millimeters on a side (e.g., 10 millimeters x 10 millimeters to 250 millimeters x 250 millimeters). In some embodiments, a cross-section of the glass substrate 110 in an x-z plane, a y-z plane, and/or an x-y plane of an example coordinate system 105, shown in FIG. 1, may be substantially rectangular (axes shown in subsequent drawings refer to the axes of the coordinate system 105), although in some further embodiments the glass substrate 110 may have rounded or beveled edges/sides/sidewalls. In some embodiments, in the top-down view of the glass substrate 110 (e.g., the x-y plane of the coordinate system 105), the glass substrate 110 may have a first length in a range of 10 millimeters to 250 millimeters, and a second length in a range of 10 millimeters to 250 millimeters, the first length perpendicular to the second length. A thickness of the glass substrate 110 (e.g., a dimension measured along the z-axis of the coordinate system 105) may be in a range of about 50 micron to 1.4 millimeters. In some embodiments, the glass substrate 110 may be a glass core, where the glass core has a thickness in a range of about 50 microns to 1.4 millimeters. In some embodiments, the glass substrate 110 may be a layer of glass comprising a rectangular prism volume, possibly with rounded or beveled edges/sides/sidewalls. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass substrate 110 may be a rectangular prism volume with sections (e.g., vias) removed and filled with other materials (e.g., metal) e.g., the TGVs 115. In some embodiments, the glass substrate 110 may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

In some implementations, together, the substrate 107, including the glass substrate 110, and the dies 114 may be referred to as a "a multi-layer die subassembly 104." The glass substrate 110 may provide mechanical stability to the multi-layer die subassembly 104, the substrate 107, and/or the microelectronic assembly 100. The glass substrate 110 may reduce warpage and may provide a more robust surface for attachment of the multi-layer die subassembly 104 to a package substrate 102 or other substrate (e.g., an interposer or a circuit board). In some embodiments of the microelectronic assembly 100 as shown in FIG. 1, the glass substrate 110 may be referred to as a core or a glass core of the microelectronic assembly 100.

In some implementations, together, the dielectric material 112 of the substrate 107 and the glass substrate 110 may be referred to as a "multi-layer glass substrate." In some such embodiments, the multi-layer glass substrate may be a coreless substrate. In some such embodiments, the glass substrate 110 may be a glass layer having a thickness in a range of about 25 microns to 50 microns. In some embodiments, the further layers 111 may also be part of the multi-layer glass substrate.

The TGVs 115 may be vias extending between a first side and a second side of the glass substrate 110 (e.g., between the bottom face and the top face of the glass substrate 110), the vias including any appropriate conductive material, e.g., a metal such as copper, silver, nickel, gold, aluminum, or other metals or alloys, for example. Openings for the TGVs 115 may be formed using any suitable process, including, for example, a direct laser drilling or laser-induced etching process (which may also be referred to as "laser patterning" or "selective laser activation"). For any of the TGVs 115, via metallization may be performed using any of the bottom-up plating techniques as described herein, e.g., any of the methods illustrated in FIGS. 4-12. Therefore, although not specifically shown in FIG. 1 or FIG. 2, any of the TGVs 115 shown in these drawings may be implemented as described with respect to the fabrication methods illustrated in FIGS. 4-12. In some embodiments, the TGVs 115 disclosed herein may have a pitch between 50 microns and 500 microns, e.g., as measured from a center of one TGV 115 to a center of an adjacent TGV 115. The TGVs 115 may have any suitable size and shape. In some embodiments, the TGVs 115 may have a circular, rectangular, or other shaped cross-section. In some embodiments, at least some of the TGVs 115 may have an hourglass shape, e.g., as shown in FIG. 2. In some embodiments, at least some of the TGVs 115 may taper down from one face of the glass substrate 110 to another, e.g., from the top face of the glass substrate 110 to the bottom face of the glass substrate 110.

The substrate 107 (e.g., further layers 111) may be coupled to a package substrate 102 by STPS interconnects 150. In particular, the top face of the package substrate 102 may include a set of conductive contacts 146. Conductive contacts 144 on the bottom face of the substrate 107 may be electrically and mechanically coupled to the conductive contacts 146 on the top face of the package substrate 102 by the STPS interconnects 150. The package substrate 102 may include an insulating material (e.g., a dielectric material formed in multiple layers, as known in the art) and one or more conductive pathways to route power, ground, and signals through the dielectric material (e.g., including conductive traces and/or conductive vias, as shown). In some embodiments, the insulating material of the package substrate 102 may be a dielectric material, such as an organic dielectric material, a fire-retardant grade 4 material (FR-4), bismaleimide triazine (BT) resin, polyimide materials, glass reinforced epoxy matrix materials, organic dielectrics with inorganic fillers or low-k and ultra-low-k dielectric (e.g., carbon-doped dielectrics, fluorine-doped dielectrics, porous dielectrics, and organic polymeric dielectrics). When the package substrate 102 is formed using standard PCB processes, the package substrate 102 may include FR-4, and the conductive pathways in the package substrate 102 may be formed by patterned sheets of copper separated by build-up layers of the FR-4. The conductive pathways in the package substrate 102 may be bordered by liners, such as adhesion liners and/or barrier liners, as suitable. In some embodiments, the package substrate 102 may be formed using a lithographically defined via packaging process. In some embodiments, the package substrate 102 may be manufactured using standard organic package manufacturing processes, and thus the package substrate 102 may take the form of an organic package. In some embodiments, the package substrate 102 may be a set of redistribution layers formed on a panel carrier by laminating or spinning on a dielectric material and creating conductive vias and lines by laser drilling and plating. In some embodiments, the package substrate 102 may be formed on a removable carrier using any suitable technique, such as a redistribution layer technique. Any method known in the art for fabrication of the package substrate 102 may be used, and for the sake of brevity, such methods will not be discussed in further detail herein.

In some embodiments, the package substrate 102 may be a lower density medium and the die 114 may be a higher density medium or have an area with a higher density medium. As used herein, the term "lower density" and "higher density" are relative terms indicating that the conductive pathways (e.g., including conductive interconnects, conductive lines, and conductive vias) in a lower density medium are larger and/or have a greater pitch than the conductive pathways in a higher density medium. In some embodiments, a higher density medium may be manufactured using a modified semi-additive process or a semi-additive build-up process with advanced lithography (with small vertical interconnect features formed by advanced laser or lithography processes), while a lower density medium may be a PCB manufactured using a standard PCB process (e.g., a standard subtractive process using etch chemistry to remove areas of unwanted copper, and with coarse vertical interconnect features formed by a standard laser process). In other embodiments, the higher density medium may be manufactured using semiconductor fabrication process, such as a single damascene process or a dual-damascene process. In some embodiments, additional dies may be disposed on the top face of the dies 114-2, 114-3. In some embodiments, additional components may be disposed on the top face of the dies 114-2, 114-3. Additional passive components, such as surface-mount resistors, capacitors, and/or inductors, may be disposed on the top face or the bottom face of the package substrate 102, or embedded in the package substrate 102.

The microelectronic assembly 100 of FIG. 1 may also include an underfill material 127. In some embodiments, the underfill material 127 may extend between the substrate 107 and the package substrate 102 around the associated STPS interconnects 150. In some embodiments, the underfill material 127 may extend between different ones of the top level dies 114-2, 114-3 and the top face of the substrate 107 around the associated DTS interconnects 140 and between the bridge die 114-1 and the top level dies 114-2, 114-3 around the DTD interconnects 130. The underfill material 127 may be an insulating material, such as an appropriate epoxy material. In some embodiments, the underfill material 127 may include a capillary underfill, non-conductive film (NCF), or molded underfill. In some embodiments, the underfill material 127 may include an epoxy flux that assists with soldering the multi-layer die subassembly 104 to the package substrate 102 when forming the STPS interconnects 150, and then polymerizes and encapsulates the STPS interconnects 150. The underfill material 127 may be selected to have a CTE that may mitigate or minimize the stress between the substrate 107 and the package substrate 102 arising from uneven thermal expansion in the microelectronic assembly 100. In some embodiments, the CTE of the underfill material 127 may have a value that is intermediate to the CTE of the package substrate 102 (e.g., the CTE of the dielectric material of the package substrate 102) and a CTE of the dies 114 and/or dielectric material 112 of the substrate 107.

The STPS interconnects 150 disclosed herein may take any suitable form. In some embodiments, a set of STPS interconnects 150 may include solder (e.g., solder bumps or balls that are subject to a thermal reflow to form the STPS interconnects 150), for example, as shown in FIG. 1, the STPS interconnects 150 may include solder between a conductive contacts 144 on a bottom face of the substrate 107 and a conductive contact 146 on a top face of the package substrate 102. In some embodiments, a set of STPS interconnects 150 may include an anisotropic conductive material, such as an anisotropic conductive film or an anisotropic conductive paste. An anisotropic conductive material may include conductive materials dispersed in a non-conductive material.

The DTD interconnects 130 disclosed herein may take any suitable form. The DTD interconnects 130 may have a finer pitch than the STPS interconnects 150 in a microelectronic assembly. In some embodiments, the dies 114 on either side of a set of DTD interconnects 130 may be unpackaged dies, and/or the DTD interconnects 130 may include small conductive bumps (e.g., copper bumps). The DTD interconnects 130 may have too fine a pitch to couple to the package substrate 102 directly (e.g., too fine to serve as DTS interconnects 140 or STPS interconnects 150). In some embodiments, a set of DTD interconnects 130 may include solder. In some embodiments, a set of DTD interconnects 130 may include an anisotropic conductive material, such as any of the materials discussed above. In some embodiments, the DTD interconnects 130 may be used as data transfer lanes, while the STPS interconnects 150 may be used for power and ground lines, among others. In some embodiments, some or all of the DTD interconnects 130 in a microelectronic assembly 100 may be metal-to-metal interconnects (e.g., copper-to-copper interconnects, or plated interconnects). In such embodiments, the DTD interconnect 130 may be bonded together (e.g., under elevated pressure and/or temperature) without the use of intervening solder or an anisotropic conductive material. Any of the conductive contacts disclosed herein (e.g., the conductive contacts 122, 124, 144, and/or 146) may include bond pads, solder bumps, conductive posts, or any other suitable conductive contact, for example. In some embodiments, some or all of the DTD interconnects 130 and/or the DTS interconnects 140 in a microelectronic assembly 100 may be solder interconnects that include a solder with a higher melting point than a solder included in some or all of the STPS interconnects 150. For example, when the DTD interconnects 130 and the DTS interconnects 140 in a microelectronic assembly 100 are formed before the STPS interconnects 150 are formed, solder-based DTD interconnects 130 and DTS interconnects 140 may use a higher-temperature solder (e.g., with a melting point above 200 degrees Celsius), while the STPS interconnects 150 may use a lower-temperature solder (e.g., with a melting point below 200 degrees Celsius). In some embodiments, a higher-temperature solder may include tin; tin and gold; or tin, silver, and copper (e.g., 96.5 % tin, 3% silver, and 0.5% copper). In some embodiments, a lower-temperature solder may include tin and bismuth (e.g., eutectic tin bismuth) or tin, silver, and bismuth. In some embodiments, a lower-temperature solder may include indium, indium and tin, or gallium.

In the microelectronic assemblies 100 disclosed herein, some or all of the DTS interconnects 140 and the STPS interconnects 150 may have a larger pitch than some or all of the DTD interconnects 130. DTD interconnects 130 may have a smaller pitch than STPS interconnects 150 due to the greater similarity of materials in the different dies 114 on either side of a set of DTD interconnects 130 than between the substrate 107 and the top level dies 114-2, 114-3 on either side of a set of DTS interconnects 140, and between the substrate 107 and the package substrate 102 on either side of a set of STPS interconnects 150. In particular, the differences in the material composition of a substrate 107 and a die 114 or a package substrate 102 may result in differential expansion and contraction due to heat generated during operation (as well as the heat applied during various manufacturing operations). To mitigate damage caused by this differential expansion and contraction (e.g., cracking, solder bridging, etc.), the DTS interconnects 140 and the STPS interconnects 150 may be formed larger and farther apart than DTD interconnects 130, which may experience less thermal stress due to the greater material similarity of the pair of dies 114 on either side of the DTD interconnects. In some embodiments, the DTS interconnects 140 disclosed herein may have a pitch between 25 microns and 250 microns. In some embodiments, the STPS interconnects 150 disclosed herein may have a pitch between 55 microns and 1000 microns, while the DTD interconnects 130 disclosed herein may have a pitch between 25 microns and 100 microns.

The microelectronic assembly 100 of FIG. 1 may also include a circuit board (not shown). The package substrate 102 may be coupled to the circuit board by second-level interconnects at the bottom face of the package substrate 102. The second-level interconnects may be any suitable second-level interconnects, including solder balls for a ball grid array arrangement, pins in a pin grid array arrangement or lands in a land grid array arrangement. The circuit board may be a motherboard, for example, and may have other components attached to it. The circuit board may include conductive pathways and other conductive contacts for routing power, ground, and signals through the circuit board, as known in the art. In some embodiments, the second-level interconnects may not couple the package substrate 102 to a circuit board but may instead couple the package substrate 102 to another IC package, an interposer, or any other suitable component. In some embodiments, the substrate 107 may not be coupled to a package substrate 102, but may instead be coupled to a circuit board, such as a PCB.

Although FIG. 1 depicts a microelectronic assembly 100 having a substrate with a particular number of dies 114 and conductive pathways provided by the conductive material 108 coupled to other dies 114, this number and arrangement are simply illustrative, and a microelectronic assembly 100 may include any desired number and arrangement of dies 114. Although FIG. 1 shows the die 114-1 as a double-sided die and the dies 114-2, 114-3 as single-sided dies, the dies 114-2, 114-3 may be double-sided dies and the dies 114 may be a single-pitch die or a mixed-pitch die. In some embodiments, additional components may be disposed on the top face of the dies 114-2 and/or 114-3. In this context, a double-sided die refers to a die that has connections on both surfaces. In some embodiments, a double-sided die may include through TSVs to form connections on both surfaces. The active surface of a double-sided die, which is the surface containing one or more active devices and a majority of interconnects, may face either direction depending on the design and electrical requirements.

Many of the elements of the microelectronic assembly 100 of FIG. 1 are included in other ones of the accompanying drawings; the discussion of these elements is not repeated when discussing these drawings, and any of these elements may take any of the forms disclosed herein. Further, various elements are illustrated in FIG. 1 as included in the microelectronic assembly 100, but, in various embodiments, some of these elements may not be included. For example, in various embodiments, the further layers 111, the underfill material 127, and the package substrate 102 may not be present in the microelectronic assembly 100. In some embodiments, individual ones of the microelectronic assemblies 100 disclosed herein may serve as a system-in-package (SiP) in which multiple dies 114 having different functionality are included. In such embodiments, the microelectronic assembly 100 may be referred to as an SiP.

FIG. 2 is a schematic cross-sectional view of another example microelectronic assembly 100 in which a glass substrate having TGVs fabricated using bottom-up plating techniques as described herein may be implemented, according to some embodiments of the present disclosure. The configuration of the embodiment shown in the figure is like that of FIG. 1, except for differences as described further. Instead of including the glass substrate 110 as a part of the substrate 107, as was shown in FIG. 1, the microelectronic assembly 100 of FIG. 2 includes a glass substrate 110 on its own, where one or more dies 114 may be coupled to the glass substrate 110. In FIG. 2, the multi-layer die subassembly 104 includes the glass substrate 110 and the plurality of dies 114 as described above. The multi-layer die subassembly 104 may have a first surface 160-1 (e.g., the bottom face) and an opposing second surface 160-2 (e.g., the top face). The glass substrate 110 may provide mechanical stability to the multi-layer die subassembly 104 and/or the microelectronic assembly 100 of FIG. 2, may reduce warpage, and may provide a more robust surface for attachment of the multi-layer die subassembly 104 to a package substrate 102 or other substrate (e.g., an interposer or a circuit board).

The glass substrate 110 may include a cavity 129 with an opening facing the second surface 160-2. In some embodiments, a further component, or a plurality of further components, may be nested, fully or at least partially, in the cavity 129. FIG. 2 illustrates an embodiment where a further component is a die 114-1, but, in other embodiments, instead or in addition to the die 114-1, another further component may be nested, fully or at least partially, in the cavity 129. In some embodiments, such components may be passive components such as capacitors or inductors. In some embodiments, such components may be active components such as logic circuits. In the embodiments, in cases where a further component, e.g., the die 114-1, is fully nested in a cavity 129, a top face of the further component may be planar with or below a top face of the glass substrate 110. In cases where a further component, e.g., the die 114-1, is partially nested in a cavity 129, a top face of the further component may extend above a top face of the glass substrate 110. The cavity 129 may be at least partially filled with a dielectric material, e.g., with a dielectric material 112A or 112B, described above. A further component, e.g., the die 114-1, may be attached to a bottom face of the cavity 129 by a die-attach film (DAF) 132. A DAF 132 may be any suitable material, including a non-conductive adhesive, die-attach film, a B-stage underfill, or a polymer film with adhesive property. A DAF 132 may have any suitable dimensions, for example, in some embodiments, a DAF 132 may have a thickness (e.g., height or z-height) between 5 microns and 10 microns.

The die 114-1 may be coupled to the dies 114-2, 114-3 in a layer above the die 114-1 through the DTD interconnects 130. The DTD interconnects 130 may be disposed between some of the conductive contacts 122 at the bottom of the dies 114-2, 114-3 and some of the conductive contacts 124 at the top of the die 114-1. Some other conductive contacts 122 at the bottom of the dies 114-2 and/or 114-3 may further couple one or more of the dies 114-2, 114-3 to the glass substrate 110 by glass substrate-to-die (GCTD) interconnects 142. The GCTD interconnects 142 may be disposed between some of the conductive contacts 122 at the bottom of the dies 114-2, 114-3 and some of the conductive contacts 128 at the top of the glass substrate 110. The GCTD interconnects 142 may be similar to the DTS interconnects 140, described above. In some embodiments, the underfill material 127 may extend between different ones of the dies 114 around the associated DTD interconnects 130 and/or GCTD interconnects 142. In some embodiments, a die 114-2 and/or a die 114-3 may be embedded in an insulating material 133. In some embodiments, an overall thickness (e.g., a z-height) of the insulating material 133 may be between 200 microns and 800 microns (e.g., substantially equal to a thickness of die 114-2 or 114-3 and the underfill material 127). In some embodiments, the insulating material 133 may form multiple layers (e.g., a dielectric material formed in multiple layers, as known in the art) and may embed one or more dies 114 in a layer. In some embodiments, the insulating material 133 may be a dielectric material, such as an organic dielectric material, a fire-retardant grade 4 material (FR-4), BT resin, polyimide materials, glass reinforced epoxy matrix materials, or low-k and ultra-low-k dielectric (e.g., carbon-doped dielectrics, fluorine-doped dielectrics, porous dielectrics, and organic polymeric dielectrics). In some embodiments, the insulating material 133 may be a mold material, such as an organic polymer with inorganic silica particles.

As shown in FIG. 2, the glass substrate 110 may further include conductive contacts 126 at the bottom of the glass substrate 110, and TGVs 115 may extend between and electrically couple conductive contacts 126 at the bottom of the glass substrate 110 and conductive contacts 128 at the top of the glass substrate 110. The conductive contacts 126, 128 may be similar to other conductive contacts disclosed herein (e.g., the conductive contacts 122, 124, 144, and/or 146), and may include bond pads, solder bumps, conductive posts, or any other suitable conductive contact, for example. As shown in FIG. 2, in some embodiments, at least some of the TGVs 115 may have an hourglass shape. For example, at least some of the TGVs 115 may has a first width at the first face of the glass substrate 110 (e.g., at the bottom face of the glass substrate 110), a second width at the second face of the glass substrate 110 (e.g., at the top face of the glass substrate 110), and a third width between the first face and the second face of the glass substrate 110, where the third width is smaller than the first width and the second width.

The dies 114-2, 114-3 may be electrically coupled to the package substrate 102 through the TGVs 115 and glass substrate-to-package substrate (GCTPS) interconnects 152, which may be power delivery interconnects or high-speed signal interconnects. The GCTPS interconnects 152 may be similar to the STPS interconnects 150, described above. The top face of the package substrate 102 may include a set of conductive contacts 146, the multi-layer die subassembly 104 may include a set of conductive contacts 126 on the first surface 160-1, and the GCTPS interconnects 152 may be between, and couple the conductive contacts 146 with corresponding ones of the conductive contacts 126. In some embodiments, the underfill material 127 may extend between the glass substrate 110 and the package substrate 102 around the associated GCTPS interconnects 152.

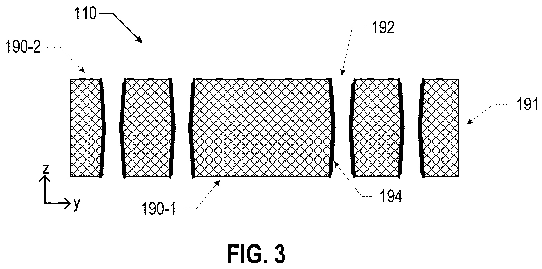

The glass substrate 110 included in a microelectronic assembly 100 as described with reference to FIG. 1 or FIG. 2 or included in any other microelectronic assembly or device, may be subject to TGV stress. For example, FIG. 3 illustrates the surfaces of a glass substrate 110 from which TGV stress may initiate, according to some embodiments of the present disclosure. As shown in FIG. 3, a glass substrate 110 may have a first face 190-1 and an opposing second face 190-2, e.g., be bottom and top faces when the glass substrate 110 is included in a microelectronic assembly 100 (where, together, the first and second faces 190-1, 190-2 may be referred to as "faces 190"). The glass substrate 110 may also include a side 191, which is a surface of the glass substrate 110 that may be referred to as an edge or a sidewall of the glass substrate 110, i.e., a surface that extends between the first face 190-1 and the second face 190-2. As further shown in FIG. 3, TGV openings 192 may be formed in the glass substrate 110, extending between the first face 190-1 and the second face 190-2. A sidewall 194 may then refer to one or more sidewalls of the TGV openings 192. When a conductive material is deposited in the TGV openings 192, TGV stress may initiate from the sidewall 194 due to CTE mismatch between the glass material of the glass substrate 110 and the conductive material in the TGV openings 192.

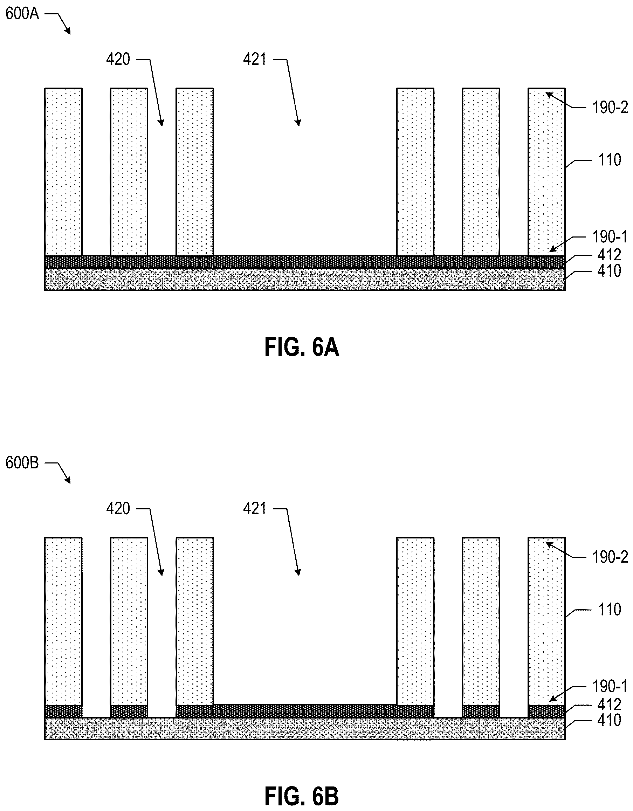

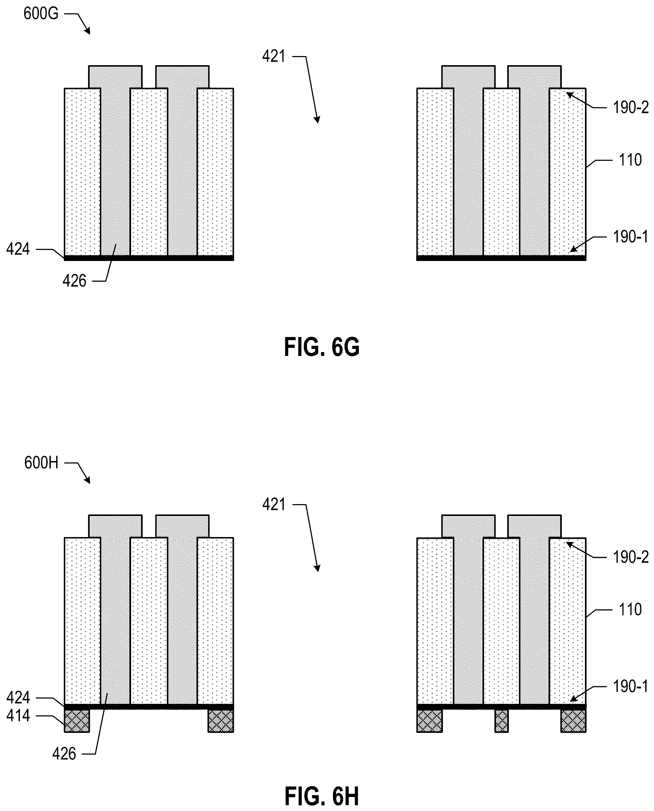

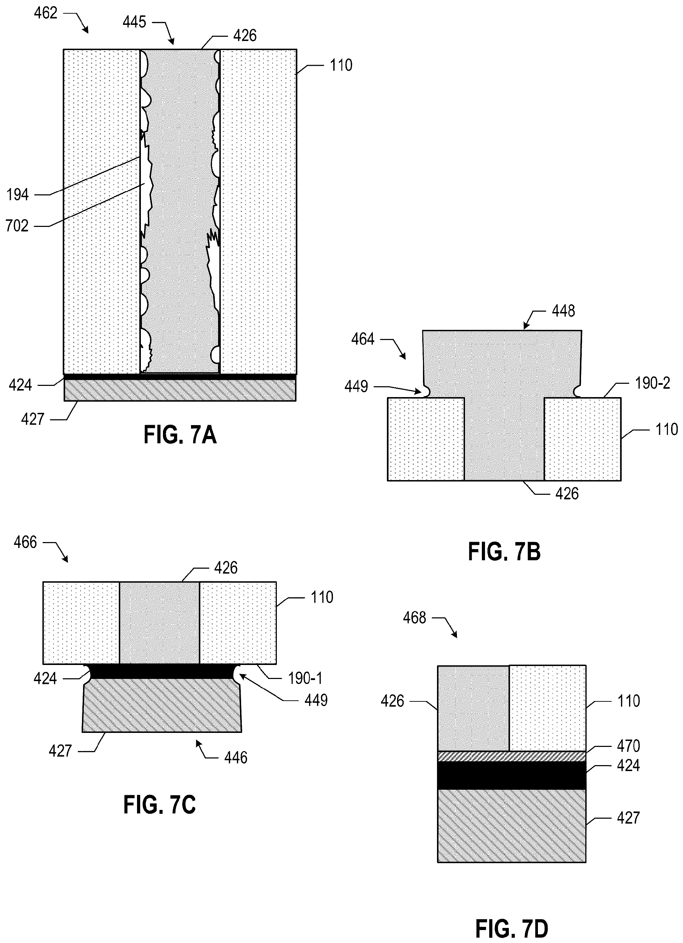

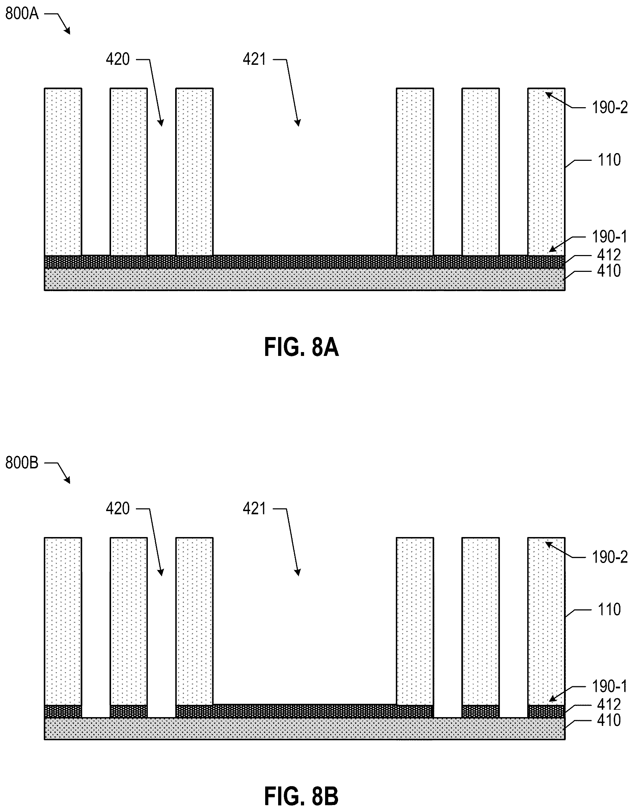

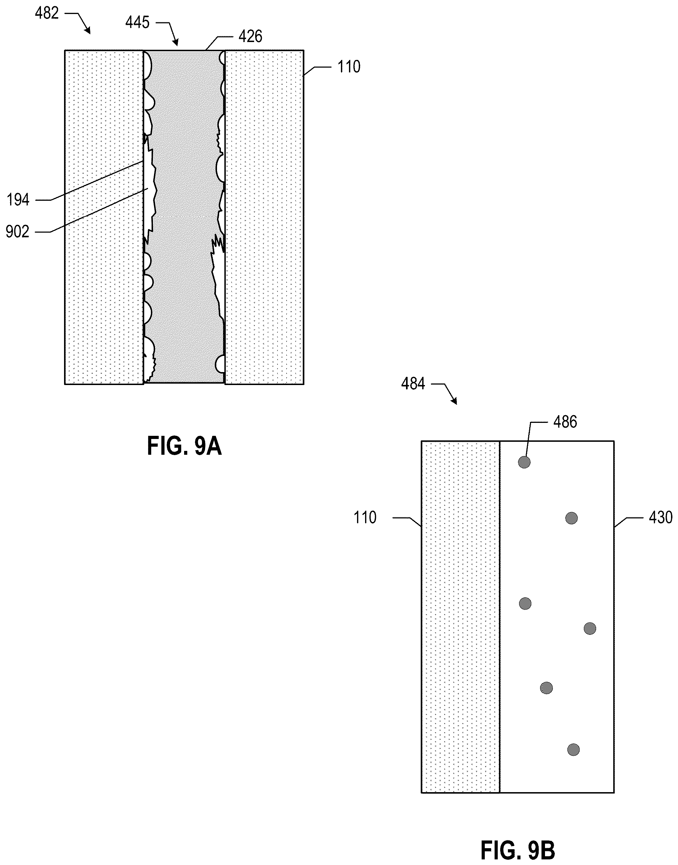

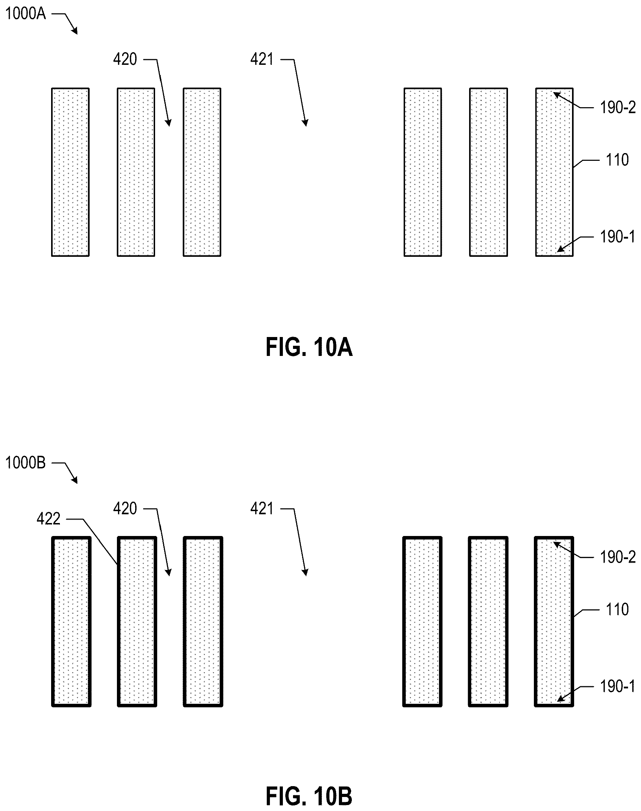

One or more techniques for TGV stress alleviation as described herein may be applied to reduce TGV stress at the sidewalls 194, before including the glass substrate 110 in a microelectronic assembly 100. Various techniques for TGV stress alleviation are based on implementing conductive vias (e.g., TGVs 115) in glass substrates using bottom-up plating without using a seed material on the sidewalls 194. In particular, three fabrication methods in accordance with such three techniques are illustrated. The first fabrication method is a method according to a bottom-up plating using SE technique, shown in FIGS. 4A-4F and FIGS. 5A-5C. The second fabrication method is a method according to a bottom-up plating using mSAP technique, shown in FIGS. 6A-6K and FIGS. 7A-7D. The third fabrication method is a method according to a bottom-up plating with flowable cavity-fill materials technique, shown in FIGS. 8A-8H and FIG. 9. For each of these techniques, the first set of drawings (e.g., FIGS. 4A-4F, FIGS. 6A-6K, and FIGS. 8A-8H) illustrate schematic illustrations of cross-sectional side views of an example glass substrate at various stages in the fabrication of TGVs, while the second set of drawings (e.g., FIGS. 5A-5C, FIGS. 7A-7D, and FIGS. 9A-9B) provide schematic illustrations of cross-sectional side views of example glass substrates showing features indicative of the use of corresponding technique of the first set of drawings. Furthermore, any of these three techniques may further be modified by including a liner on sidewalls of TGVs to serve as a buffer layer between the glass substrate and conductive material(s) in the TGVs, and modified first, second, and third fabrication methods are shown in, respectively, FIGS. 10A-10H, FIGS. 11A-11M, and FIGS. 12A-12J.

Turning to the first fabrication method, FIGS. 4A-4F provide schematic illustrations of cross-sectional side views of microelectronic assemblies with an example glass substrate 110 at various stages in the fabrication of TGVs formed by bottom-up plating using SE, according to some embodiments of the present disclosure.

As shown with a microelectronic assembly 400A of FIG. 4A, the first fabrication method may begin with providing a glass substrate 110 with one or more TGV openings 420 extending between the first face 190-1 and the second face 190-2 of the glass substrate 110. In some embodiments, a cavity 421 may also be provided in the glass substrate 110. Descriptions provided above with reference to the cavity 129 may be applicable to the cavity 421. Although four TGV openings 420 and one cavity 421 are shown in the present drawings, in other embodiments, the microelectronic assembly 400A-400F may include any number of one or more TGV openings 420 and any number of zero or more cavities 421. The TGV openings 420 and the cavity 421 may be formed in the glass substrate 110 using any suitable process, such as direct laser drilling or laser-induced etching processes. The illustration of FIG. 4A and subsequent drawings of the bottom-up plating methods described herein show the microelectronic assemblies in a cross-sectional side view, e.g., a view of a y-z plane similar to the illustrations of FIGS. 1-3. A right upper corner of FIG. 4A further illustrates an inset 402, showing a miniaturized version of the top-down view (i.e., an x-y plane view) of the microelectronic assembly 400A, illustrating an example of how the cavity 421 may be arranged within the glass substrate 110, and showing a vertical dotted line indicating a plane along which the cross-sections of FIG. 4A and subsequent drawings of the bottom-up plating methods described herein are shown.

As further shown in FIG. 4A, the microelectronic assembly 400A may further include a metal coil 410 attached to the first face 190-1 of the glass substrate 110 and, optionally, an adhesive 412 between the metal coil 410 and the first face 190-1. The metal coil 410 may assist in the electroplating plating in a subsequent process, e.g., the metal coil 410 may play a role in creating a uniform electric field and distributing current evenly within the plating solution. Materials of the metal coil 410 may be selected based on factors such as electrical requirements (e.g., materials with high electrical conductivity such as copper may be preferred if efficiency is paramount), type of electroplating solutions (e.g., acidic solutions such as copper sulfate baths may require more corrosion-resistant materials like titanium or platinum-coated titanium), cost considerations, and process stability. In various embodiments, the metal coil 410 may include a conductive material such as a metal or a metal alloy, with metals such as copper, titanium, platinum, nickel, gold, palladium, or silver. In some embodiments, an adhesive 412 may be used to attach the metal coil 410 to the first face 190-1. In some embodiments, the adhesive 412 may be a conductive adhesive (e.g., a silver epoxy or an epoxy with other conductive particles), to provide both mechanical attachment and electrical conductivity. In such embodiments, the adhesive 412 may remain at the bottom of the TGV openings 420 when electroplating starts, as long as the material of the adhesive 412 is compatible with the electroplating conditions (e.g., compatible with electroplating bath and resistant to chemical attack). In other embodiments, the adhesive 412 may be a non-conductive adhesive (e.g., a non-conductive epoxy) or an adhesive that is not compatible with the electroplating conditions, in which case the adhesive 412 may be removed from the bottom of the TGV openings 420 when electroplating starts.

As shown with a microelectronic assembly 400B of FIG. 4B, in the embodiments when the adhesive 412 is a non-conductive adhesive or an adhesive that is not compatible with the electroplating conditions, the first fabrication method may proceed with removing the adhesive 412 from the bottom of the TGV openings 420, exposing the metal coil 410 at the bottom of the TGV openings 420. In some embodiments, the adhesive 412 may be removed from the bottoms of the TGV openings 420 using an etching process such as a dry etch, e.g., a reactive ion etch (RIE). While FIG. 4B illustrates that the adhesive 412 is also removed from the bottom of the cavity 421, in other embodiments, the adhesive 412 may remain at the bottom of the cavity 421 (e.g., as illustrated in FIG. 6B).

Subsequent drawings continue with the illustration of the embodiment as shown in FIG. 4B. However, in the embodiments where the adhesive 412 includes a conductive adhesive that is compatible with the electroplating conditions, the process of FIG. 4B may be omitted and the adhesive 412 may remain at the bottom of the TGV openings 420. Furthermore, subsequent drawings continue with the illustration of embodiments where the adhesive 412 is used, but, in other embodiments, the metal coil 410 may be attached to the first face 190-1 without using an adhesive (i.e., for all of the techniques described herein, the adhesive 412 may be omitted).

As shown with a microelectronic assembly 400C of FIG. 4C, the first fabrication method may then proceed with performing bottom-up plating, in which a conductive fill material 426 is deposited into the TGV openings 420, starting from the bottoms of the TGV openings 420 and progressively filling the TGV openings 420 to the top and, possibly, beyond. FIG. 4C illustrates that, as a result of performing bottom-up plating, the TGV openings 420 and the cavity 421 may be filled with the conductive fill material 426. The conductive fill material426 may include any suitable conductive material, e.g., a metal, a metal alloy, or a combination of metals, e.g., a low-resistivity metal such as copper. In some embodiments, the conductive fill material426 may include one or more metals such as copper, ruthenium, nickel, gold, palladium, platinum, or silver.

As shown with a microelectronic assembly 400D of FIG. 4D, the first fabrication method may further include performing SE of the conductive materials of the microelectronic assembly 400C, defined by features of a mask material 414. The mask material 414 may include any suitable material that allows etching of the conductive fill material 426 from the top and the bottom of the glass substrate 110 and of the metal coil 410 from the bottom of the glass substrate 110 except for the portions of the conductive fill material 426 and the metal coil 410 covered by the features of the mask material 414. For example, positive or negative photoresist may be used to form the features of the mask material 414 as shown in FIG. 4D. The features of the mask material 414 of the microelectronic assembly 400D may be formed using any suitable patterning technique such as photolithographic or e-beam patterning.

As shown in FIG. 4D, as a result of performing the SE, the TGV openings 420 may remain substantially filled with the conductive fill material 426, but a portion of the conductive fill material 426 in the cavity 421 may remain. In this case, the first fabrication method may further include a subsequent SE process, as shown with a microelectronic assembly 400E of FIG. 4E, where the conductive materials in the TGV openings 420 are still protected with features of the mask material 414 (which may be different from the features used in the process of FIG. 4E), but the conductive fill material 426 is removed from the cavity 421. Performing SE in two steps, as is shown with FIG. 4D and FIG. 4E, may be advantageous in terms of carefully controlling the critical dimensions of the etch.

The first fabrication method may conclude with removing the mask material 414, as is shown with a microelectronic assembly 400F of FIG. 4F. Any suitable process may be used to remove the mask material 414, such as ashing or photoresist strip. In the microelectronic assembly 400F, the TGV openings 420 at least partially filled with the conductive fill material 426 form conductive vias in the form of TGVs 415. The TGVs 415 are one example of any of the TGVs 115, described herein. In the microelectronic assembly 400F, portions of the metal coil metal coil 410 below the TGV openings 420 and below the first face 190-1 form conductive contacts 436 the bottom of the glass substrate 110, while portions of the conductive fill material426 above the TGV openings 420 and above the second face 190-2 form conductive contacts 438 at the top of the glass substrate 110. Thus, the TGVs 415 may extend between and electrically couple conductive contacts 436 at the bottom of the glass substrate 110 and conductive contacts 438 at the top of the glass substrate 110 similar to how the TGVs 115 may extend between and electrically couple conductive contacts 126 at the bottom of the glass substrate 110 and conductive contacts 128 at the top of the glass substrate 110.

FIGS. 4A-4F illustrate idealized structures according to the first fabrication method, e.g., showing rectilinear shapes with flat walls and right-angle corners, which is done for ease of illustration. FIGS. 5A-5C show some example features that may be detectable in real-life structures fabricated using the first fabrication method of FIGS. 4A-4F, providing illustrations of how features of FIGS. 4A-4F may not look so "ideal" when any of the structures are examined using e.g., SEM or TEM images. FIGS. 5A-5C provide schematic illustrations of cross-sectional side views of portions of example glass substrates showing features indicative of the use of the fabrication method of FIGS. 4A-4F, according to some embodiments of the present disclosure. In particular, FIG. 5A illustrates a portion 452 identified in FIG. 4F with a dashed contour, FIG. 5B illustrates a portion 454 identified in FIG. 4F with a dashed contour, and FIG. 5C illustrates a portion 456 identified in FIG. 4F with a dashed contour.

FIG. 5A illustrates that, in some embodiments, one or more voids 502 may be present between the conductive fill material 426 and one or more of the sidewalls 194 of the TGVs 415. FIG. 5A illustrates a plurality of such voids along the sidewalls 194. In some embodiments, the voids 502 may be air gaps. In some embodiments, a width of a void 502 (e.g., a dimension measured in a horizontal direction of the page of the drawings) may be between about 20 nanometers and about 200 nanometers, e.g., between about 40 nanometers and about 140 nanometers.

FIG. 5B illustrates that, in some embodiments, the conductive contacts 438 may have a tapered shape, where their width (a dimension measured in a horizontal direction of the page of the drawings) may taper/decrease in a direction away from the glass substrate 110. Thus, as shown in FIG. 5B, the conductive contacts 438 may be narrower at the top (i.e., farthest away from the glass substrate 110) and wider at the bottom (i.e., closest to the glass substrate 110). In some embodiments, an angle between a sidewall of the conductive contact 438 and the first face 190-1 of the glass substrate 110 may be less than about 90 degrees, e.g., less than 85 degrees, e.g., may be between about 60 degrees and about 90 degrees or between about 60 degrees and about 85 degrees. The angle may depend on factors such as chemistry used for etching, thickness of the conductive contacts 438, and tools used for fabrication.

Similar to FIG. 5B, FIG. 5C illustrates that, in some embodiments, the conductive contacts 436 may have a tapered shape, where their width (a dimension measured in a horizontal direction of the page of the drawings) may also taper/decrease in a direction away from the glass substrate 110. Thus, as shown in FIG. 5C, the conductive contacts 436 may be wider at the top (i.e., closest to the glass substrate 110) and narrower at the bottom (i.e., farthest away from the glass substrate 110). In some embodiments, an angle between a sidewall of the conductive contact 436 and the second face 190-2 of the glass substrate 110 may be similar to that of the angle between a sidewall of the conductive contact 438 and the first face 190-1 of the glass substrate 110, where these two angles may, but do not have to be, the same.

In some implementations, the sidewall profiles of the conductive contacts 436, 438 formed with the SE process of FIGS. 4A-4F may be defined by the etch chemistry used in this fabrication method to form the conductive contacts 436, 438. For example, due to the SE process, in some embodiments, one or more sidewalls of the conductive contacts 438 may have concave portions, as shown in FIG. 5B, and/or sidewalls of the conductive contacts 436 may have concave portions, as shown in FIG. 5C. Furthermore, the absence of any seed material (such as, e.g., the seed material 424 used in the second fabrication method described herein and shown, e.g., in FIGS. 6A-6K) on the sidewalls 194 of the TGVs 415, on the first face 190-1 or on the second face 190-2 of the glass substrate 110 are also features indicative of the use of the first fabrication method of FIGS. 4A-4F.

Turning to the second fabrication method, FIGS. 6A-6K provide schematic illustrations of cross-sectional side views of microelectronic assemblies with an example glass substrate 110 at various stages in the fabrication of TGVs formed by bottom-up plating using mSAP, according to some embodiments of the present disclosure.

As shown with a microelectronic assembly 600A of FIG. 6A, the second fabrication method may begin with providing a glass substrate 110 with one or more TGV openings 420 extending between the first face 190-1 and the second face 190-2 of the glass substrate 110, a metal coil 410 attached to the first face 190-1 of the glass substrate 110 and, optionally, a cavity 421 and an adhesive 412 between the metal coil 410 and the first face 190-1. Descriptions provided for the microelectronic assembly 400A of FIG. 4A are applicable to the microelectronic assembly 600A of FIG. 6A and, in the interest of brevity, are not repeated.

As shown with a microelectronic assembly 600B of FIG. 6B, in the embodiments when the adhesive 412 is a non-conductive adhesive or an adhesive that is not compatible with the electroplating conditions, the second fabrication method may proceed with removing the adhesive 412 from the bottom of the TGV openings 420, exposing the metal coil 410 at the bottom of the TGV openings 420. Descriptions provided for the microelectronic assembly 400B of FIG. 4B are applicable to the microelectronic assembly 600B of FIG. 6B and, in the interest of brevity, are not repeated. While FIG. 6B illustrates that the adhesive 412 remains at the bottom of the cavity 421, in other embodiments, the adhesive 412 may also be removed from the bottom of the cavity 421 (e.g., as illustrated in FIG. 4A).

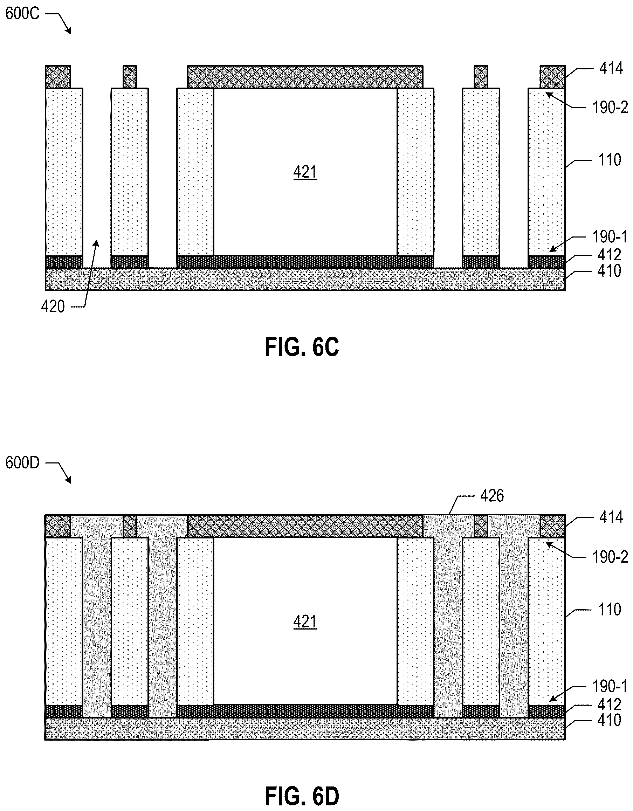

As shown with a microelectronic assembly 600C of FIG. 6C, the second fabrication method may further include providing features of a mask material 414 over the second face 190-2 of the glass substrate 110. The mask material 414 may include any suitable material that allows performing bottom-up plating in the openings of the glass substrate 110 that are not covered by the features of the mask material 414 (e.g., the TGV openings 420 may be left uncovered, as shown in FIG. 6C). For example, positive or negative photoresist may be used to form the features of the mask material 414 as shown in FIG. 6C. The features of the mask material 414 of the microelectronic assembly 600C may be formed using any suitable patterning technique such as photolithographic or e-beam patterning.

As shown with a microelectronic assembly 600D of FIG. 6D, the second fabrication method may then proceed with performing bottom-up plating, in which a conductive fill material 426 is deposited into the openings in the mask material 414, starting from the bottoms of the TGV openings 420 and progressively filling the TGV openings 420 to the top and, possibly, beyond. FIG. 6D illustrates that, as a result of performing bottom-up plating, the TGV openings 420 (but not the cavity 421, because the cavity 421 was covered up by the mask material 414) may be filled with the conductive fill material 426.

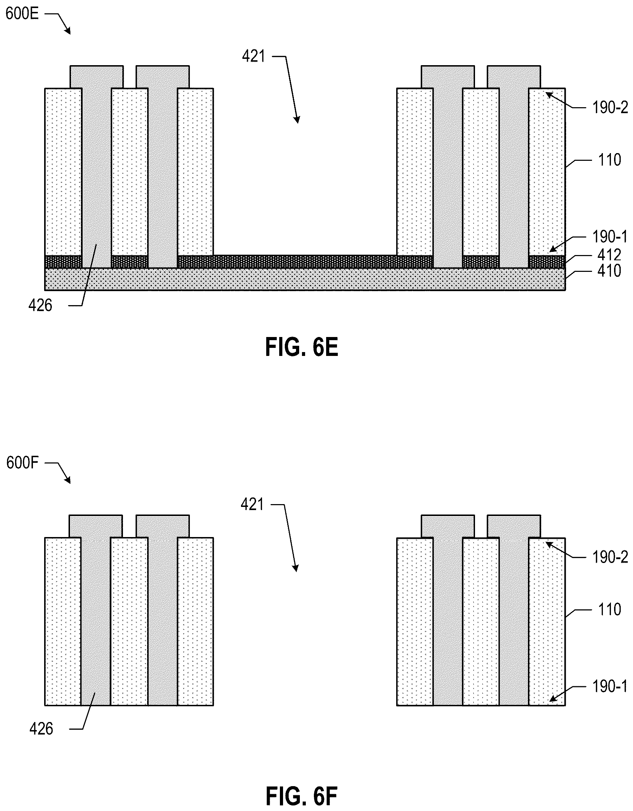

The second fabrication method may further include removing the mask material 414 from the second face 190-2, as is shown with a microelectronic assembly 600E of FIG. 6E. Any suitable process may be used to remove the mask material 414, such as ashing or photoresist strip.

The second fabrication method may then proceed with removing the metal coil 410 and the adhesive 412 from the first face 190-1 of the glass substrate 110, as is shown with a microelectronic assembly 600F of FIG. 6F. Any suitable process may be used to remove the metal coil 410 and the adhesive 412, e.g., any suitable planarization process. As a result, the conductive fill material 426 in the TGV openings 420 may be exposed at the first face 190-1, as shown in FIG. 6F.

Next, a layer of a seed material 424 may be deposited over the first face 190-1. The seed material 424 may include any suitable conductive material, e.g., a metal, a metal alloy, or a combination of metals, e.g., a low-resistivity metal such as copper, that can be deposited in a thin layer on substantially non-conductive surfaces such as the first face 190-1 of the glass substrate 110. The seed material 424 provides a conductive surface for uniform and controlled deposition of a conductive material in a subsequent step of forming conductive contacts over the first face 190-1. For example, the seed material 424 may serve as a foundation or base for the subsequent electroplating of a thicker layer of metal over the first face 190-1, e.g., of the conductive material 427. In some embodiments, the seed material424 may include one or more metals such as copper, ruthenium, nickel, gold, palladium, platinum, or silver. In various embodiments, a thickness of the layer of the seed material 424, e.g., as measured in a direction perpendicular to the first face 190-1, may be between about 5 nanometer and 20 micron, e.g., between about 10 nanometers and 15 micron, or between about 10 nanometers and 1 micron. In various embodiments, the seed material 424 may be deposited using any suitable deposition technique such as chemical vapor deposition (CVD), atomic layer deposition (ALD), or physical vapor deposition (PVD). In some embodiments, the seed material 424 may be deposited as a conformal layer. In some embodiments, the seed material 424 may include two or more layers of different conductive materials, deposited over the first face 190-1 sequentially. For example, the seed material 424 may include a layer of a first material deposited over the first face 190-1, and then a layer of a second material deposited on the first material. The first material may be a conductive material that has good adhesive properties in terms of adhesion between the first material and the first face 190-1, and, possibly, in terms of adhesion between the first material and the second material. The second material may be a conductive material that may protect the first material from oxidation before and/or during deposition of the conductive material in a subsequent process. In some embodiments, a further material may be present between the seed material424 and the first face 190-1 of the glass substrate 110, e.g., to improve adhesion of the seed material 424 to the glass substrate 110 (e.g., as shown in FIG. 7D). For example, the further material may include titanium that may act as an adhesion promoter of the seed material 424 to the glass substrate 110. However, if the seed material 424 is a metal that has relatively good adhesion properties to glass, then no adhesion promoter material may need to be used in between and the seed material424 may be in contact (e.g., in direct physical contact) with the glass substrate 110. In such embodiments, the other side of the seed material 424 may be in contact (e.g., in direct physical contact) with the conductive material 427 of the conductive contact 446.

In various embodiments, material compositions of the seed material 424 and the conductive fill material426 may be the same or different. However, grain structures of the seed material 424 and the conductive fill material 426 are likely to be different even when the material compositions of the seed material424 and the conductive fill material 426 are the same, resulting in a grain boundary being present between the seed material 424 and the conductive fill material 426. For example, in some embodiments, an average grain size of the seed material 424 may be different (e.g., smaller) from an average grain size of the conductive material 426. In some embodiments, an average grain orientation of the seed material424 may be different from an average grain orientation of the conductive material 426. For example, the seed material424 may include much smaller and more uniformly oriented grains than the conductive fill material 426.

As shown with a microelectronic assembly 600H of FIG. 6H, the second fabrication method may further include providing features of a mask material 414 over the seed material 424 at the first face 190-1. The mask material 414 may include any suitable material that allows forming conductive contacts at the first face 190-1 in areas that are not covered by the features of the mask material 414. For example, positive or negative photoresist may be used to form the features of the mask material 414 at the first face 190-1, as shown in FIG. 6H. The features of the mask material 414 of the microelectronic assembly 600H may be formed using any suitable patterning technique such as photolithographic or e-beam patterning.

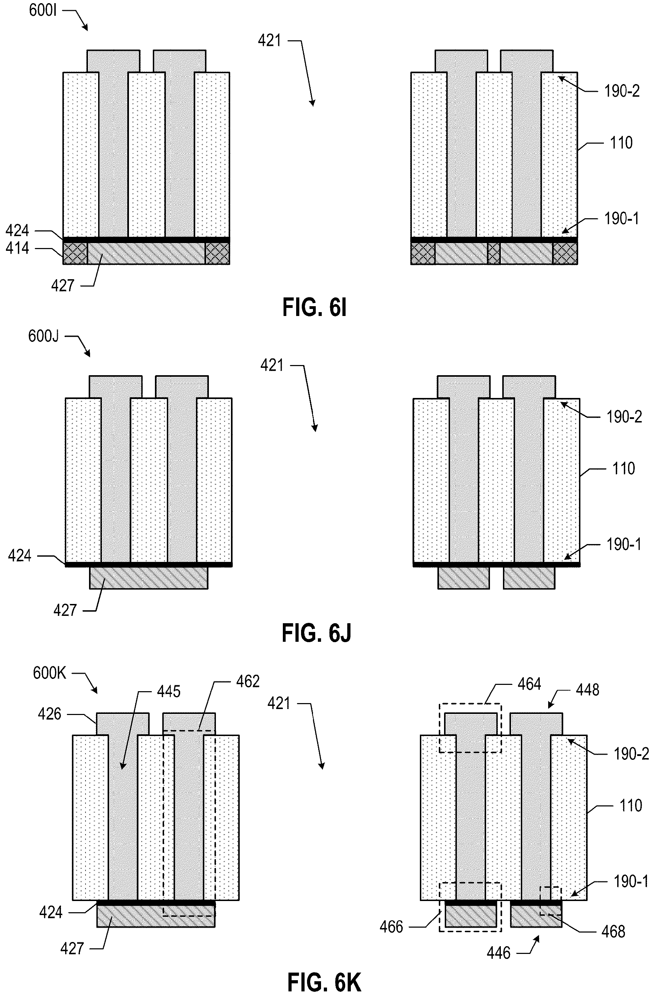

As shown with a microelectronic assembly 600I of FIG. 6I, the second fabrication method may then proceed with depositing a conductive material 427, from the side of the first face 190-1, into openings not covered up with the mask material 414 at the first face 190-1. The conductive fill material 427 may be deposited using any suitable deposition technique such as electroplating, ALD, CVD, or PVD. In some embodiments, material compositions of any two or more of the conductive material427, the conductive fill material 426, and at least portions of the seed material 424 may be substantially the same, e.g., any two or more of the conductive material 427, the conductive fill material 426, and at least portions of the seed material424 may be, or may include, copper. In other embodiments, material compositions of any one or more of the conductive material 427, the conductive fill material 426, and at least portions of the seed material424 may be different from any one or more of the conductive material 427, the conductive fill material426, and at least portions of the seed material 424.

The second fabrication method may further include removing the mask material 414 from the first face 190-1, as is shown with a microelectronic assembly 600J of FIG. 6J. Any suitable process may be used to remove the mask material 414 from the first face 190-1, such as ashing or photoresist strip.

The second fabrication method may conclude with removing portions of the seed material 424 that are not covered by the conductive material 427 at the first face 190-1 and that have been exposed by removing the mask material 414 from the first face 190-1, as is shown with a microelectronic assembly 600K of FIG. 6K. To that end, any suitable etching process may be used, such as dry etch or wet etch. In the microelectronic assembly 600K, the TGV openings 420 at least partially filled with the conductive fill material 426 form conductive vias in the form of TGVs 445. The TGVs 445 are an example of any of the TGVs 115, described herein. In the microelectronic assembly 600K, portions of the conductive material 427 and the seed material424 at the first face 190-1 form conductive contacts 446 the bottom of the glass substrate 110, while portions of the conductive fill material 426 above the TGV openings 420 and above the second face 190-2 form conductive contacts 448 at the top of the glass substrate 110. Thus, the TGVs 445 may extend between and electrically couple conductive contacts 446 at the bottom of the glass substrate 110 and conductive contacts 448 at the top of the glass substrate 110 similar to how the TGVs 115 may extend between and electrically couple conductive contacts 126 at the bottom of the glass substrate 110 and conductive contacts 128 at the top of the glass substrate 110.

FIGS. 6A-6K illustrate idealized structures according to the second fabrication method, e.g., showing rectilinear shapes with flat walls and right-angle corners, which is done for ease of illustration. FIGS. 7A-7D show some example features that may be detectable in real-life structures fabricated using the second fabrication method of FIGS. 6A-6K, providing illustrations of how features of FIGS. 6A-6K may not look so "ideal" when any of the structures are examined using e.g., SEM or TEM images. FIGS. 7A-7D provide schematic illustrations of cross-sectional side views of portions of example glass substrates showing features indicative of the use of the fabrication method of FIGS. 6A-6K, according to some embodiments of the present disclosure. In particular, FIG. 7A illustrates a portion 462 identified in FIG. 6K with a dashed contour, FIG. 7B illustrates a portion 464 identified in FIG. 6K with a dashed contour, FIG. 7C illustrates a portion 466 identified in FIG. 6K with a dashed contour, and FIG. 7D illustrates a portion 468 identified in FIG. 6K with a dashed contour.

FIG. 7A illustrates that, in some embodiments, one or more voids 702 may be present between the conductive fill material 426 and one or more of the sidewalls 194 of the TGVs 445. FIG. 7A illustrates a plurality of such voids along the sidewalls 194. Descriptions of the void 502 are applicable to the voids 702 and, therefore, in the interest of brevity, are not repeated.

FIG. 7B illustrates that, in some embodiments, a taper of the conductive contacts 448 may be much less than that of the conductive contacts 438 of FIG. 5B and, if any taper is present, the width of the conductive contacts 448 may increase in a direction away from the glass substrate 110. Thus, as shown in FIG. 7B, the conductive contacts 448 may be the wider at the top (farthest from the glass substrate 110) and narrower at the bottom, closest to the glass substrate 110; although in other embodiments, the direction of taper may be reversed to what is shown in FIG. 7B (i.e., it may be similar to that shown in FIG. 5B, but with less tapering). In some embodiments, an angle between a sidewall of the conductive contact 448 and the first face 190-1 of the glass substrate 110 may be between about 85 degrees and about 95 degrees.

Similar to FIG. 7B, FIG. 7C illustrates that, in some embodiments, a taper of the conductive contacts 446 may be much less than that of the conductive contacts 436 of FIG. 5C and, if any taper is present, the width of the conductive contacts 446 may increase in a direction away from the glass substrate 110. Thus, as shown in FIG. 7C, the conductive contacts 446 may be the narrower at the top (closest to the glass substrate 110) and wider at the bottom (farthest away from the glass substrate 110); although in other embodiments, the direction of taper may be reversed to what is shown in FIG. 7C (i.e., it may be similar to that shown in FIG. 5C, but with less tapering). In some embodiments, an angle between a sidewall of the conductive contact 446 and the second face 190-2 of the glass substrate 110 may be similar to that of the angle between a sidewall of the conductive contact 448 and the first face 190-1 of the glass substrate 110, where these two angles may, but do not have to be, the same.

In some implementations, the sidewall profiles of the conductive contacts 446, 448 formed with the mSAP process of FIGS. 6A-6K may be defined by factors such as the photoresist swelling, whether positive or negative photoresist is used, and which specific brand of photoresist is used to form the conductive contacts 446, 448. Also, the presence of the seed material 424 at the first face 190-1 but absence of the seed material 424 at the second face 190-2 of the glass substrate 110 (e.g., absence of the seed material424 between the conductive contact 448 and the TGVs 445) and on the sidewalls 194 of the TGVs 445 may be features indicative of the use of the method of FIGS. 6A-6K. For example, as shown in FIG. 7B, the conductive contact 448 may be in contact (e.g., in direct physical contact) with a portion of the TGV 445 at the second face 190-2 of the glass substrate 110 (i.e., there is no seed material 424 present between the conductive contact 448 and the TGV 445 at the second face 190-2 of the glass substrate 110). On the other hand, as shown in FIG. 7C, the seed material 424 may be present between the conductive contact 446 and a portion of the TGV 445 at the first face 190-1 of the glass substrate 110.

Furthermore, FIGS. 7B and 7C illustrate example footer undercuts 449 that may be present at sidewalls of the portions of the conductive contacts 446, 448 that are closest to the glass substrate 110. In some embodiments, a width of such footer undercuts 449 (e.g., a dimension measured in a horizontal direction of the page of the drawings) may be between about 500 nanometers and about 800 nanometers, e.g., between about 580 nanometers and about 750 nanometers. The presence of the footer undercuts 449 may also be features indicative of the use of the mSAP process of FIGS. 6A-6K.

The portion 468 shown in FIG. 7D illustrates an example where a further material 470 is present between the seed material 424 and the first face 190-1 of the glass substrate 110. For example, first, the further material 470 may be deposited over the first face 190-1, and then the seed material 424 is deposited on the further material470. The further material 470 may be a conductive material that has good adhesive properties with respect to glass, so that it can adhere to the first face 190-1 of the glass substrate 110, and, possibly, also has good adhesive properties with respect to the seed material 424. In some embodiments, the seed material 424 may be a conductive material that may protect the further material 470 from oxidation before and/or during deposition of the conductive material 426 in a subsequent process. In some embodiments, the further material 470 may include titanium, while the seed material424 may include copper. In some embodiments, the further material 470 may further be present between the seed material 424 and the conductive fill material 426 of the TGV 445.

Turning to the third fabrication method, FIGS. 8A-8H provide schematic illustrations of cross-sectional side views of microelectronic assemblies with an example glass substrate 110 at various stages in the fabrication of TGVs formed by bottom-up plating with flowable cavity-fill materials, according to some embodiments of the present disclosure.

As shown with a microelectronic assembly 800A of FIG. 8A, the third fabrication method may begin with providing a glass substrate 110 with one or more TGV openings 420 and a cavity 421 extending between the first face 190-1 and the second face 190-2 of the glass substrate 110, where a metal coil 410 is attached to the first face 190-1 of the glass substrate 110, possibly with a use of an adhesive 412 between the metal coil 410 and the first face 190-1. Descriptions provided for the microelectronic assembly 400A of FIG. 4A are applicable to the microelectronic assembly 800A of FIG. 8A and, in the interest of brevity, are not repeated.

As shown with a microelectronic assembly 800B of FIG. 8B, in the embodiments when the adhesive 412 is a non-conductive adhesive or an adhesive that is not compatible with the electroplating conditions, the third fabrication method may proceed with removing the adhesive 412 from the bottom of the TGV openings 420, exposing the metal coil 410 at the bottom of the TGV openings 420. Descriptions provided for the microelectronic assembly 400B of FIG. 4B are applicable to the microelectronic assembly 800B of FIG. 8B and, in the interest of brevity, are not repeated. While FIG. 8B illustrates that the adhesive 412 remains at the bottom of the cavity 421, in other embodiments, the adhesive 412 may also be removed from the bottom of the cavity 421 (e.g., as illustrated in FIG. 4A).

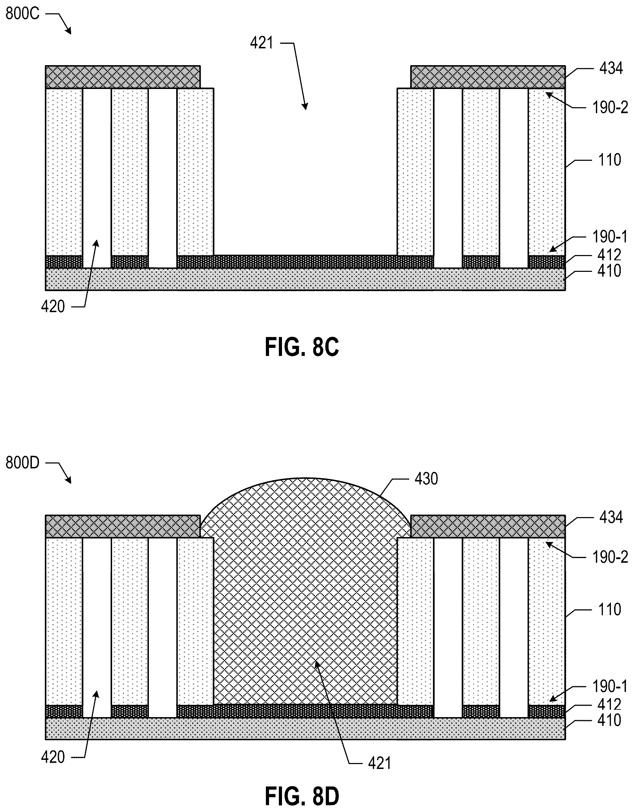

As shown with a microelectronic assembly 800C of FIG. 8C, the third fabrication method may further include providing features of a mask 434 over the second face 190-2 of the glass substrate 110, covering the TGV openings 420 but leaving the cavity 421 open. In some embodiments, positive or negative photoresist may be used to form the features of the mask 434 as shown in FIG. 8C, similar to the mask material 414. In other embodiments, the mask 434 may be a metal mask. In some embodiments, the features of the mask 434 of the microelectronic assembly 800C may be formed using any suitable patterning technique such as photolithographic or e-beam patterning.

As shown with a microelectronic assembly 800D of FIG. 8D, the third fabrication method may then proceed with depositing a flowable cavity-fill material 430 into all openings not covered by the mask 434. Thus, as shown in FIG. 8D, the flowable cavity-fill material 430 may be deposited to plug the cavity 421. FIG. 8D also illustrates how the flowable cavity-fill material 430 above the cavity 421 may extend slightly past the second face 190-2 of the glass substrate 110. In various embodiments, the flowable cavity-fill material 430 may include any dielectric materials that are sufficiently flowable to fill the cavity 421. In some embodiments, the flowable cavity-fill material 430 may include an oxide material or an epoxy material with a high degree of flowability. The flowable cavity-fill material 430 would be different from ABF which also includes epoxy materials. In particular, ABF includes a combination of epoxy materials, glass filler particles, and a hardener material. The glass filler particles help ABF to maintain a desired CTE (e.g., to have a CTE close to that of the glass substrate 110) and electrical performance characteristics (e.g., low loss). In ABF, the epoxy resins hold the fillers together. In contrast, the flowable cavity-fill material 430 would contain much less or substantially no glass filler particles, compared to ABF, to provide much higher flowability than ABF, so that the flowable cavity-fill material 430 can conform and fill any gaps in the cavity 421. In some embodiments, plugging of the cavity 421 using the flowable cavity-fill material 430 may be performed using a squeegee to apply the epoxy paste through the mask 434, possibly assisted with back-side vacuum to ensure the flowable cavity-fill material 430 flows through the cavity 421 without creating voids. In this case, the presence of the mask 434 will protect the TGV openings 420 from getting filled with the flowable cavity-fill material 430. After filling the cavity 421 with the flowable cavity-fill material 430, the flowable cavity-fill material 430 may be soft-cured to mechanically stiffen so that it can be grinded or planarized later.

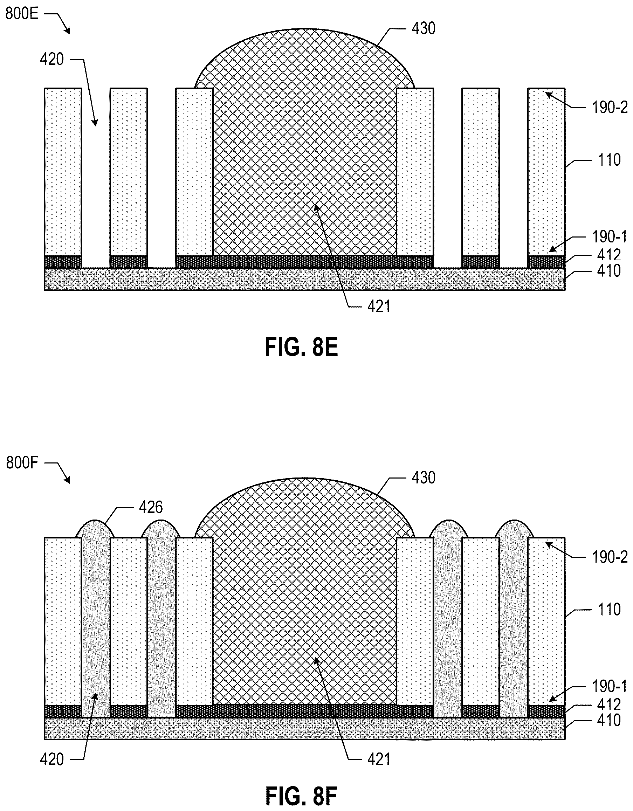

Once the flowable cavity-fill material 430 has been deposited to plug the cavity 421, the mask 434 may be removed to open up the TGV openings 420, as shown with a microelectronic assembly 800E of FIG. 8E.

The third fabrication method may then proceed with performing bottom-up plating, in which a conductive fill material 426 is deposited into the openings in the microelectronic assembly 800E. Because the cavity 421 is plugged with the flowable cavity-fill material 430, the openings in the microelectronic assembly are the TGV openings 420, and the bottom-up plating will start from the bottoms of the TGV openings 420, progressively filling the TGV openings 420 to the top and, possibly, beyond. FIG. 8F illustrates that, as a result of performing bottom-up plating, the TGV openings 420 (but not the cavity 421, because the cavity 421 was plugged with the flowable cavity-fill material 430) may be filled with the conductive fill material 426.

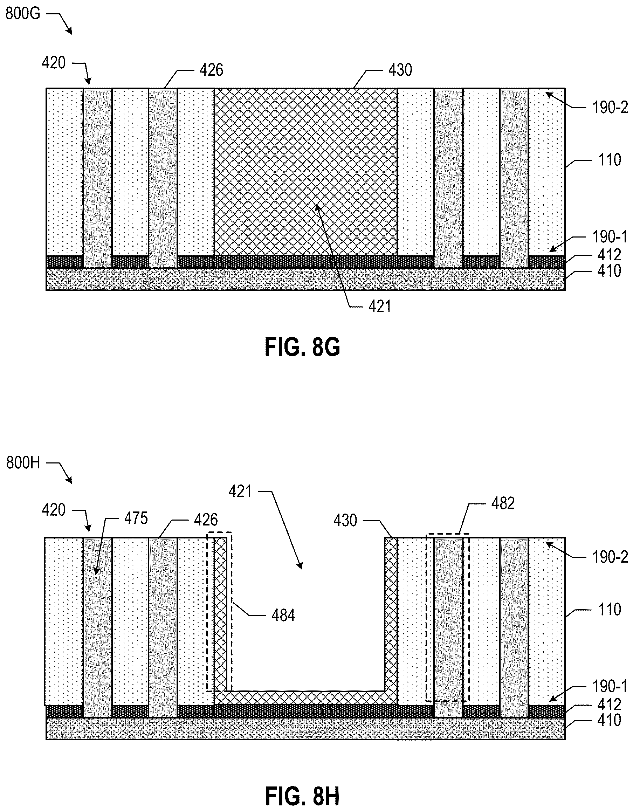

As shown with a microelectronic assembly 800G of FIG. 8G, the third fabrication method may then proceed with performing planarization at the second face 190-2 of the glass substrate 110. Because the flowable cavity-fill material 430 is different from ABF, it is possible to planarize the flowable cavity-fill material430 and the conductive fill material 426 in a single process, which advantageously reduces the number of planarization steps using in fabrication. As a result, the flowable cavity-fill material430 and the conductive fill material426 may be substantially coplanar at the second face 190-2 of the glass substrate 110.

A microelectronic assembly 800H shown in FIG. 8H illustrates that, in some embodiments of the third fabrication method, the flowable cavity-fill material 430 may be substantially removed from the cavity 421, but a portion of it may still remain on sidewalls and, possibly, at the bottom of the cavity 421. In some embodiments, a thickness of the remaining flowable cavity-fill material 430, e.g., as measured substantially perpendicular to the sidewalls of the cavity 421, may be between about 10 microns and about 2-3 mm, e.g., between about 20 microns and about 500 microns, or between about 50 microns and about 100 microns. In the microelectronic assembly 800H, the TGV openings 420 at least partially filled with the conductive fill material 426 form conductive vias in the form of TGVs 475. The TGVs 475 are an example of any of the TGVs 115, described herein.

Although not specifically shown in the present drawings, the third fabrication method may also include a process of removing the metal coil 410 and the adhesive 412 from the first face 190-1 of the glass substrate 110, as was explained with reference to the microelectronic assembly 600F of FIG. 6F. In such embodiments, the flowable cavity-fill material 430 and the conductive fill material 426 may be substantially coplanar at the first face 190-1 of the glass substrate 110.

FIGS. 8A-8H illustrate idealized structures according to the third fabrication method, e.g., showing rectilinear shapes with flat walls and right-angle corners, which is done for ease of illustration. FIGS. 9A-9B show some example features that may be detectable in real-life structures fabricated using the third fabrication method of FIGS. 8A-8H. FIGS. 9A-9B provide schematic illustrations of cross-sectional side views of portions of example glass substrates showing features indicative of the use of the fabrication method of FIGS. 8A-8H, according to some embodiments of the present disclosure. In particular, FIG. 9A illustrates a portion 482 identified in FIG. 8H with a dashed contour, and FIG. 9B illustrates a portion 484 identified in FIG. 8H with a dashed contour.

FIG. 9A illustrates that, in some embodiments, one or more voids 902 may be present between the conductive fill material 426 and one or more of the sidewalls 194 of the TGVs 475. FIG. 9A illustrates a plurality of such voids along the sidewalls 194. Descriptions of the void 502 are applicable to the voids 902 and, therefore, in the interest of brevity, are not repeated.

FIG. 9B illustrates that, in some embodiments, the flowable cavity-fill material430 may have zero or more glass filler particles 486, but much less than in ABF. In some embodiments, a total volume of the glass filler particles 486 in a given volume of the flowable cavity-fill material 430 may be less than about 70%, e.g., less than about 60% or less than about 50% or less than about 15%.

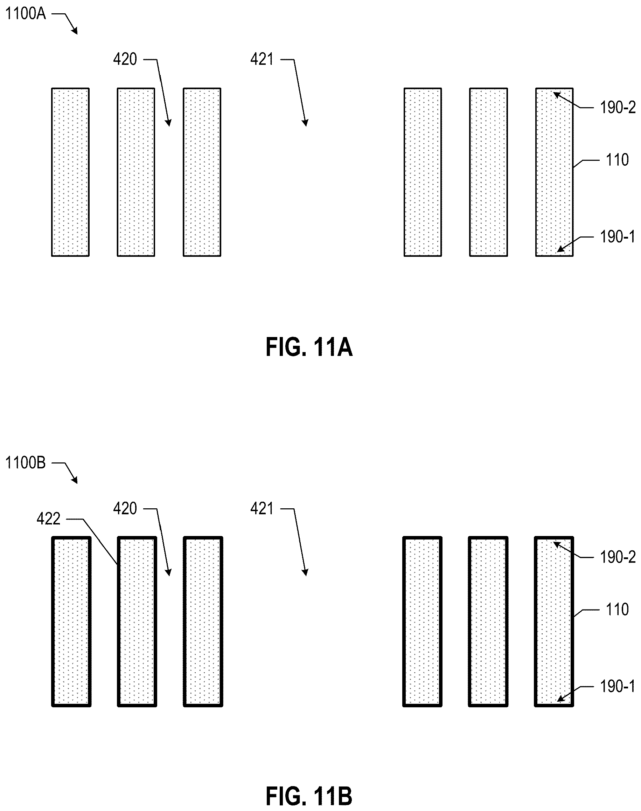

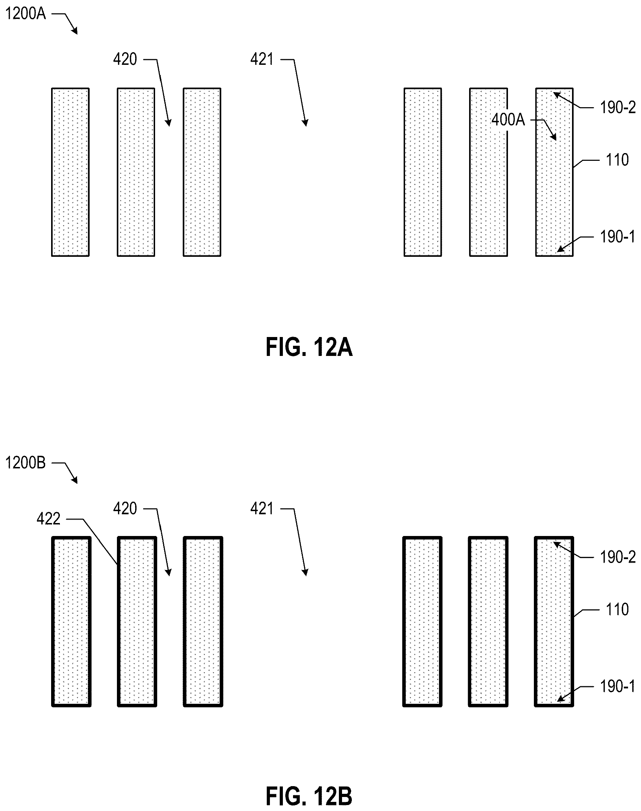

As described above, any of the three techniques for bottom-up plating as described herein may further be modified by including a liner on sidewalls of TGVs to serve as a buffer layer between the glass substrate and conductive material(s) in the TGVs. FIGS. 10A-10H illustrate a modified first fabrication method of FIGS. 4A-4F, FIGS. 11A-11M illustrate a modified second fabrication method of FIGS. 6A-6K, and FIGS. 12A-12J illustrate a modified third fabrication method of FIGS. 8A-8H.

Turning to the modified first fabrication method, FIGS. 10A-10H provide schematic illustrations of cross-sectional side views of microelectronic assemblies with an example glass substrate 110 at various stages in the fabrication of TGVs formed by bottom-up plating using SE in combination with the use of a liner 422, according to some embodiments of the present disclosure.

As shown with a microelectronic assembly 1000A of FIG. 10A, the modified first fabrication method may begin with providing a glass substrate 110 with one or more TGV openings 420 extending between the first face 190-1 and the second face 190-2 of the glass substrate 110 and, possibly, with a cavity 421, as described with reference to FIG. 4A, except that the microelectronic assembly 1000A may not yet include the metal coil 410 and the adhesive 412 at the first face 190-1 of the glass substrate 110.

As shown with a microelectronic assembly 1000B of FIG. 10B, the modified first fabrication method may then proceed with depositing the liner 422 on at least sidewalls 194 of the TGV openings 420 and the cavity 421. In various embodiments, the liner 422 may be deposited using any suitable deposition technique such as CVD, ALD, or PVD. In some embodiments, besides being deposed as a liner in the TGV openings 420 and in the cavity 421, the liner 422 may also be deposited over the first face 190-1, the second face 190-2, or both faces 190-1 and 190-2 (as is shown in FIG. 10B and subsequent drawings), depending on the deposition technique used to provide the liner 422. In such embodiments, the liner 422 deposited over the first face 190-1 and/or the second face 190-2 may be materially continuous with the liner 422 on the sidewalls of the TGV openings 420 and the cavity 421. In some embodiments, portions of the liner 422 on the sidewalls of the TGV openings 420 and the cavity 421 may be in contact (e.g., in direct physical contact) with the sidewalls of the TGV openings 420 and the cavity 421 (e.g., in contact with the glass substrate 110 at the sidewalls of the TGV openings 420 and the cavity 421). In some embodiments, a thickness of the liner 422 may be between about 200 nanometers and about 10 microns, e.g., between about 200 nanometers and about 5 microns, or between about 500 nanometers and about 1 micron. In some embodiments, the liner 422 may be deposited as a conformal layer, i.e., it may be conformal to the shapes of the underlying surfaces over which the liner 422 is deposited.

The liner 422 may include any suitable material that may separate the glass materials of the glass substrate 110 at the sidewalls of the TGV openings 420 and the cavity 421 and the conductive fill material 426 that will later be deposited in the TGV openings 420 and the cavity 421, help smoothen the glass surface at the sidewalls of the TGV openings 420 and the cavity 421, and resist tensile stresses caused by, e.g., contraction of the metals subsequently filled into the TGV openings 420 and the cavity 421. In some embodiments, the liner 422 may include any suitable material that may help as a stress-absorbing layer between the glass materials of the glass substrate 110 at the sidewalls of the TGV openings 420 and the cavity 421 and the 426 that will later be deposited in the TGV openings 420 and the cavity 421. In some embodiments, the liner 422 may include a material having a relatively low modulus, e.g., having Young's modulus below about 30 GPa, e.g., below about 10 GPA, e.g., between about 1 GPa and 30 GPa, between about 3 GPa and 30 GPa, between about 1 GPa and 20 GPa, or between about 1 GPa and 15 GPa, where the Young's modulus may be defined as the ratio of stress to strain in a material undergoing deformation. In some embodiments, the liner 422 may include a material having a modulus smaller than that of the glass substrate 110 and/or having a modulus smaller than that of the conductive fill material 426 deposited in a later process.

In some embodiments, the liner 422 may include a polymer material, e.g., an organic polymer such as polyimide (PI). In other embodiments, the liner 422 may include an organic material other than a polymer, e.g., monomers or oligomers. In some embodiments, the liner 422 may include a homopolymer, which is a polymer composed of repeating units of a single type of monomer. Simple signal chemical system organic liners such as homopolymers may be particularly advantageous for use as the liner 422 because they may be relatively easy to manufacture and because they can be adapted readily for use as the liner 422. In some embodiments, the liner 422 may include poly-para-xylylene (which is also commonly referred to as "parylene"), such as parylene N, parylene C, parylene D, or halogen free poly-para-xylylene. In other embodiments, the liner 422 may include a heteropolymer, which is a polymer composed of repeating units of two or more types of monomers or oligomers. For example, the liner 422 may include heteropolymers such as polyester (PET), polyurethane (PU), polycarbonate (PC), polyvinyl chloride (PVC), or polybenzoxazole (PBO).

In other embodiments, the liner 422 may include a material that is not a polymer, e.g., an inorganic non-polymer material. In some such embodiments, the liner 422 may include inorganic materials such as carbon-doped oxide (CDO), low modulus SiOx, silicon oxycarbide (SiOC), or other low-k dielectrics.

In some embodiments, a CTE of the liner 422 may be smaller than a CTE of the conductive fill material426, e.g., smaller than about 17 ppm/K or smaller than about 15 ppm/K or 10 ppm/K, e.g., the CTE of the material having a relatively high modulus may be between about 3 ppm/K and about 12 ppm/K, or between about 3 ppm/K and about 10 ppm/K. Placing a material with such a relatively low CTE as the material that is in contact with the sidewalls of the TGV openings 420 and the cavity 421 may reduce the CTE difference with the glass materials of the glass substrate 110, compared to the metal(s) of the conductive fill material426, which may help reduce the CTE mismatch-induced stresses.

In some embodiments, the liner 422 may include two or more layers of different materials (e.g., the liner material may include two or more layers of materials having different material compositions). For example, the liner 422 may include a layer of a material having a relatively high modulus and a layer of a material having a relatively low modulus. The material having a relatively low modulus may include any of the materials described above with reference to the liner 422. The material having a relatively high modulus may, e.g., have Young's modulus above about 30 GPa, e.g., above about 50 GPA, e.g., between about 85 GPa and about 190 GPa or between about 100 GPa and about 600 GPa. The material having a relatively high modulus may include a material having a modulus larger than that of the glass substrate 110 and/or having a modulus (e.g., Young's modulus) larger than that of the conductive fill material426 deposited in a later process. Some examples of materials that may be used as the material having a relatively high modulus in the liner 422 are inorganic materials, e.g., inorganic materials that include silicon and oxygen (e.g., silicon oxide), materials that include silicon and nitrogen (e.g., silicon nitride), materials that include silicon, oxygen, and nitrogen (e.g., silicon oxynitride), or materials that include one or more metals and oxygen (e.g., metal oxides such as aluminum oxide or hafnium oxide). Other examples of materials that may be used as the material having a relatively high modulus are organosilicates (e.g., materials that contain both organic (carbon-based) and inorganic (e.g., silicon-based) components in their chemical structure), such as methylsiloxanes (dimethylsiloxanes), phenylsiloxanes (diphenylsiloxanes), or polysilsesquioxanes.

In some embodiments where the liner 422 includes a layer of a material having a relatively high modulus and a layer of a material having a relatively low modulus, the material having a relatively high modulus may be closer to the glass substrate 110 than the material having a relatively low modulus. Implementing a material with a higher modulus as a portion of the liner 422 that is in direct contact with glass may help with reducing tensile stresses caused by, e.g., contraction of the metals subsequently filled into the TGV openings 420 and the cavity 421. In some embodiments, the material having a relatively high modulus may have a relatively low CTE (e.g., a CTE between about 3 ppm/K and about 10-12 ppm/K), which may be particularly advantageous in terms of reducing the CTE mismatch-induced stresses. Furthermore, the material having a relatively high modulus placed directly along the sidewalls of the TGV openings 420 and the cavity 421 may help smoothen the glass surface at the sidewalls. Implementing a material with a lower modulus as a portion of the liner 422 that is closer to the metals subsequently filled into the TGV than the higher-modulus material portion may help with reducing compressive stresses caused by, e.g., expansion of the metals subsequently filled into the TGV. The material having a relatively low modulus may act as a stress-absorbing layer. In some embodiments, the material having a relatively low modulus may have a higher CTE than the material having a relatively high modulus (e.g., a CTE above about 15 ppm/K), although, in other embodiments, the material having a relatively low modulus may have a lower CTE. In some embodiments, the material having a relatively high modulus may include an inorganic material such as silicon oxide or silicon nitride, while the material having a relatively low modulus may include an organic material such as parylene. In some embodiments, a thickness of any of the material having a relatively low modulus or the material having a relatively high modulus may be between about 200 nanometers and about 10 microns, e.g., between about 200 nanometers and about 5 microns, or between about 500 nanometers and about 1 micron. In some embodiments, the material having a relatively low modulus may be deposited as a conformal layer over the material having a relatively high modulus.

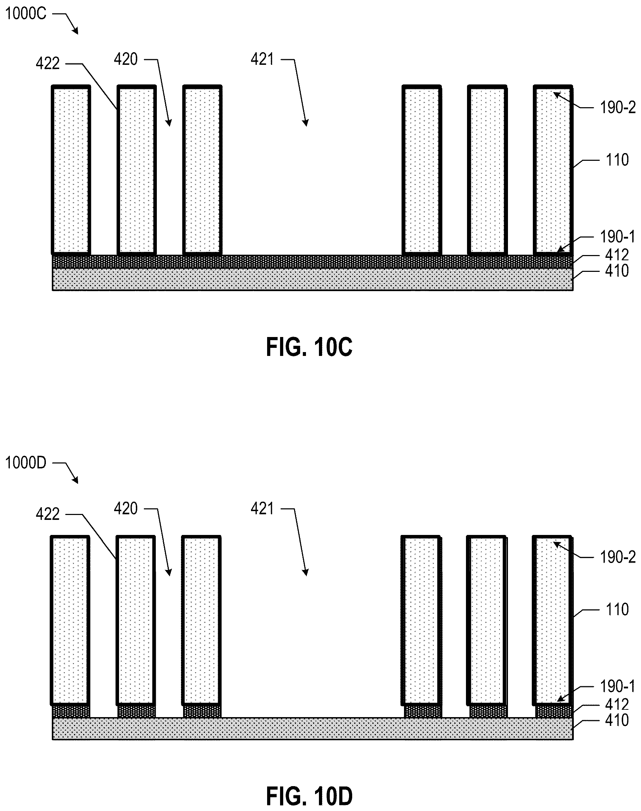

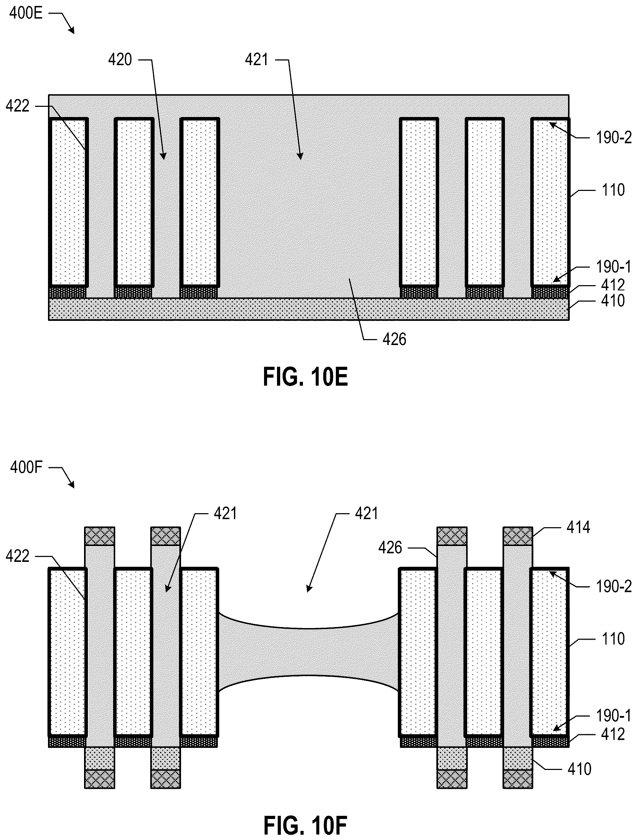

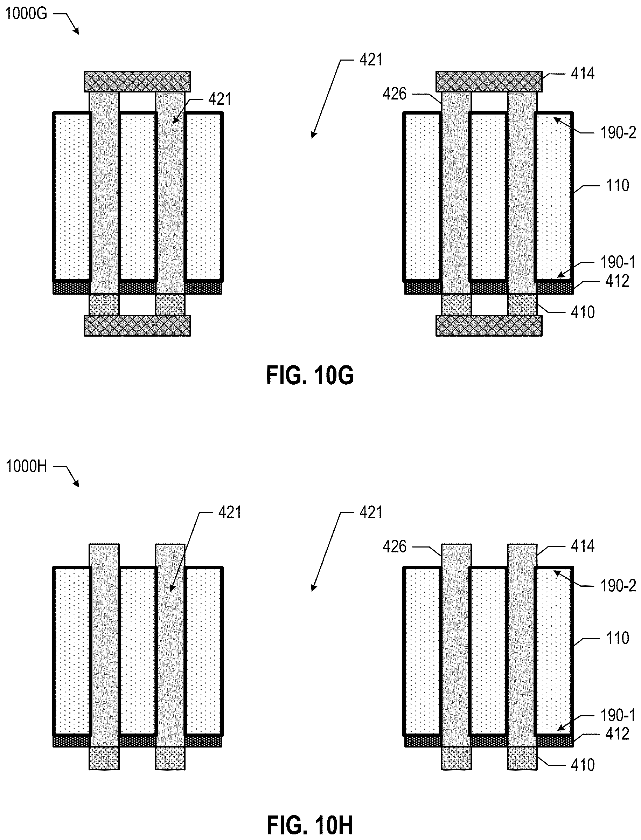

After depositing the liner 422, the modified first fabrication method may then proceed with processes of the first fabrication method as described above but applied to a glass substrate 110 with the liner 422. Thus, FIG. 10C illustrates a microelectronic assembly 1000C which is substantially the same as the microelectronic assembly 400A but with the liner 422, FIG. 10D illustrates a microelectronic assembly 1000D which is substantially the same as the microelectronic assembly 400B but with the liner 422, FIG. 10E illustrates a microelectronic assembly 1000E which is substantially the same as the microelectronic assembly 400C but with the liner 422 (in particular, where the liner 422 is present between the conductive fill material 426 and the glass substrate 110 at the sidewalls 194 of the TGV openings 420), FIG. 10F illustrates a microelectronic assembly 1000F which is substantially the same as the microelectronic assembly 400D but with the liner 422, FIG. 10G illustrates a microelectronic assembly 1000G which is substantially the same as the microelectronic assembly 400E but with the liner 422, and FIG. 10H illustrates a microelectronic assembly 1000H which is substantially the same as the microelectronic assembly 400F but with the liner 422.

Turning to the modified second fabrication method, FIGS. 11A-11M provide schematic illustrations of cross-sectional side views of microelectronic assemblies with an example glass substrate 110 at various stages in the fabrication of TGVs formed by bottom-up plating using mSAP in combination with the use of a liner 422, according to some embodiments of the present disclosure.

As shown with a microelectronic assembly 1100A of FIG. 11A, the modified second fabrication method may begin with providing a glass substrate 110 with one or more TGV openings 420 extending between the first face 190-1 and the second face 190-2 of the glass substrate 110 and, possibly, with a cavity 421, as described with reference to FIG. 6A, except that the microelectronic assembly 1100A may not yet include the metal coil 410 and the adhesive 412 at the first face 190-1 of the glass substrate 110.

As shown with a microelectronic assembly 1100B of FIG. 11B, the modified second fabrication method may then proceed with depositing the liner 422 on at least sidewalls 194 of the TGV openings 420 and the cavity 421. Descriptions of the liner 422 provided with reference to the modified first fabrication method are applicable to the modified second fabrication method and, in the interest of brevity, are not repeated.

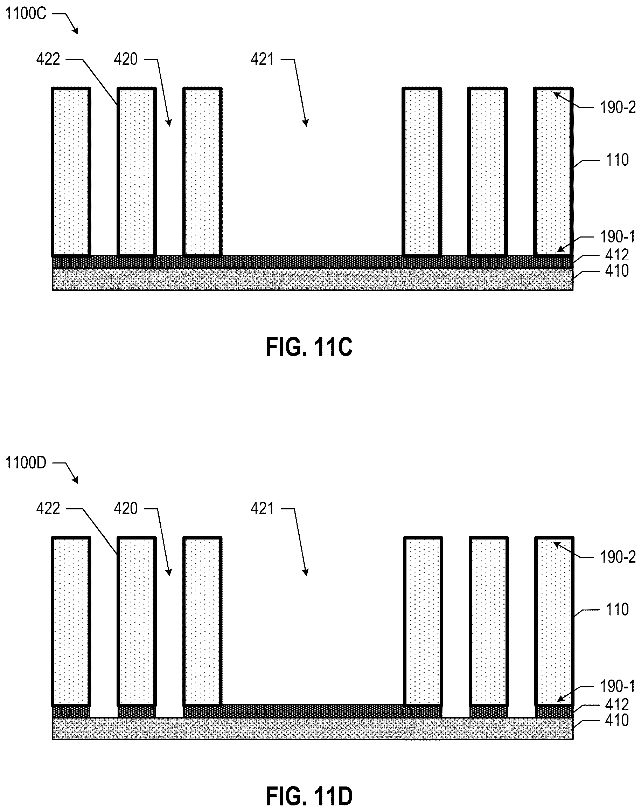

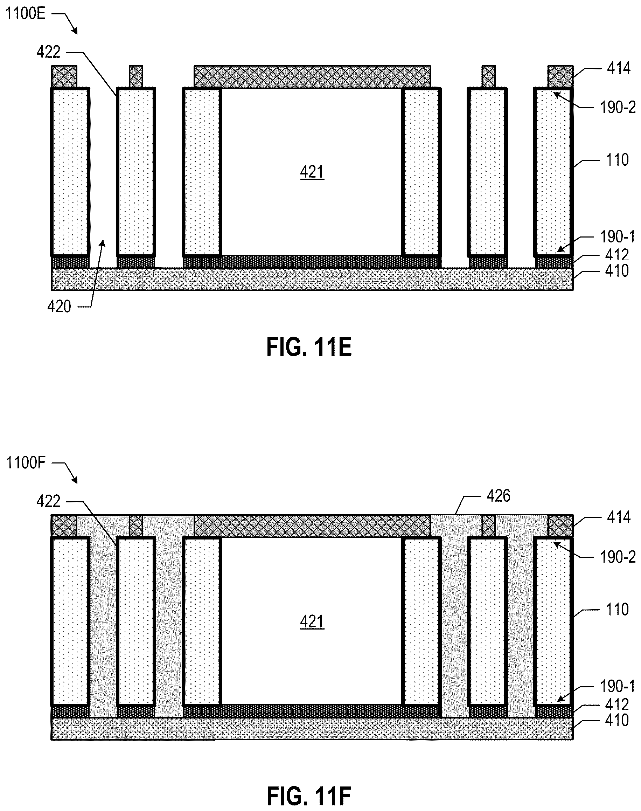

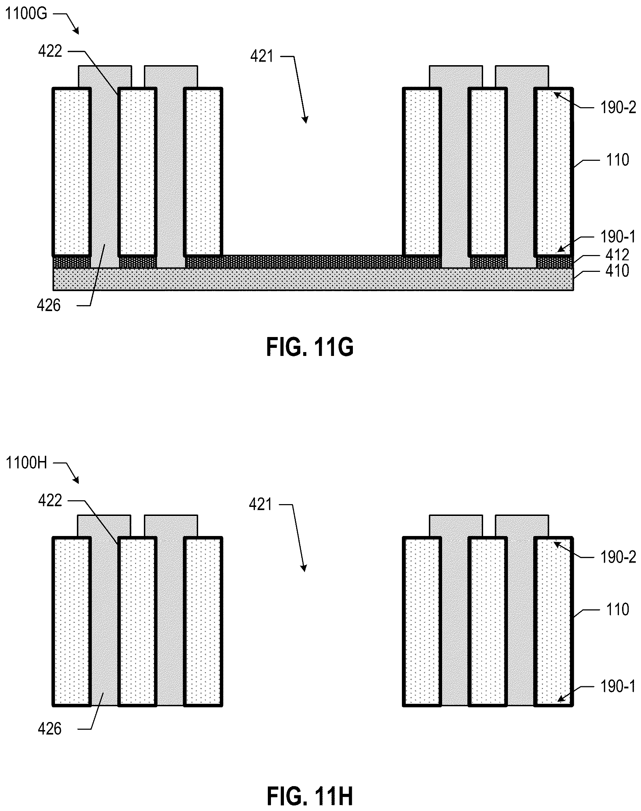

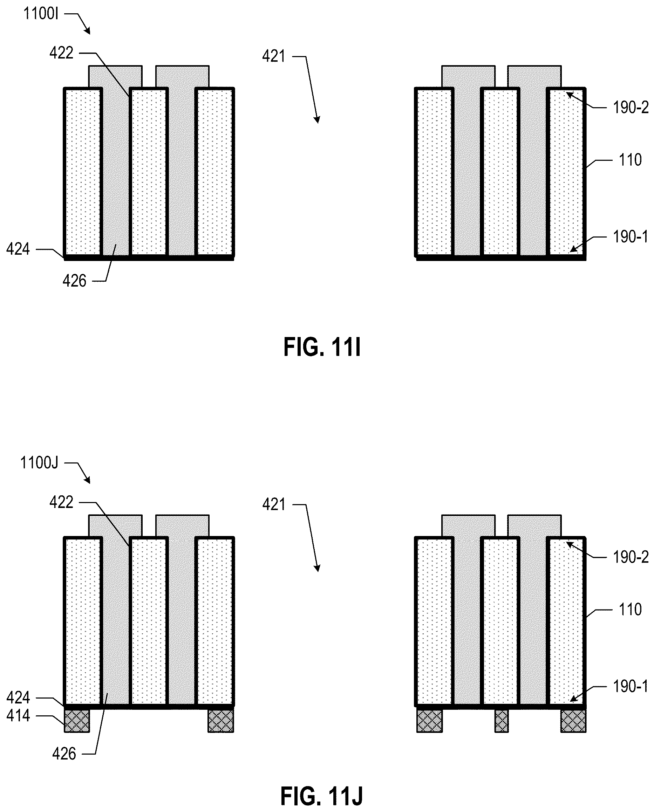

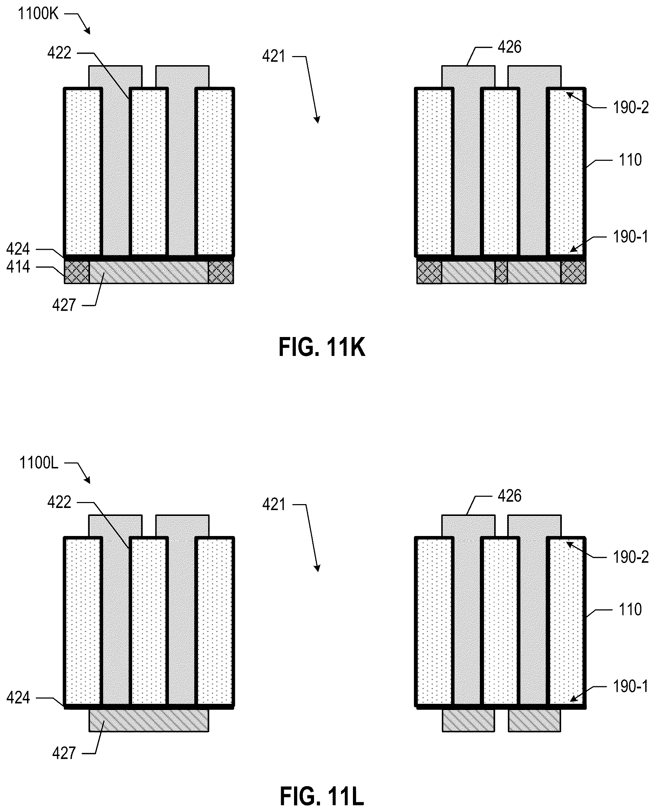

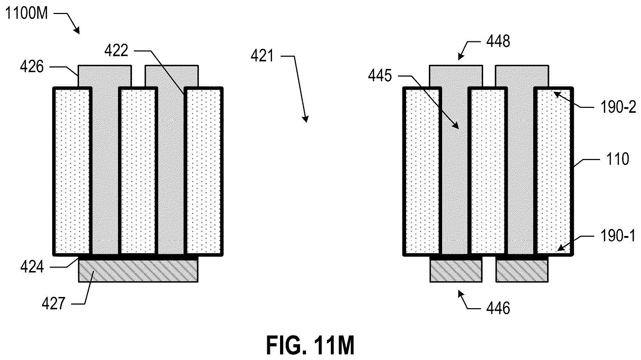

After depositing the liner 422, the modified second fabrication method may then proceed with processes of the second fabrication method as described above but applied to a glass substrate 110 with the liner 422. Thus, FIG. 11C illustrates a microelectronic assembly 1100C which is substantially the same as the microelectronic assembly 600A but with the liner 422, FIG. 11D illustrates a microelectronic assembly 1100D which is substantially the same as the microelectronic assembly 600B but with the liner 422, FIG. 11E illustrates a microelectronic assembly 1100E which is substantially the same as the microelectronic assembly 600C but with the liner 422, FIG. 11F illustrates a microelectronic assembly 1100F which is substantially the same as the microelectronic assembly 600D but with the liner 422, FIG. 11G illustrates a microelectronic assembly 1100G which is substantially the same as the microelectronic assembly 600E but with the liner 422, FIG. 11H illustrates a microelectronic assembly 1100H which is substantially the same as the microelectronic assembly 600F but with the liner 422, FIG. 11I illustrates a microelectronic assembly 1100I which is substantially the same as the microelectronic assembly 600G but with the liner 422, FIG. 11J illustrates a microelectronic assembly 1100J which is substantially the same as the microelectronic assembly 600H but with the liner 422, FIG. 11K illustrates a microelectronic assembly 1100K which is substantially the same as the microelectronic assembly 600I but with the liner 422, FIG. 11L illustrates a microelectronic assembly 1100L which is substantially the same as the microelectronic assembly 600J but with the liner 422, and FIG. 11M illustrates a microelectronic assembly 1100M which is substantially the same as the microelectronic assembly 600K but with the liner 422.

Turning to the modified third fabrication method, FIGS. 12A-12J provide schematic illustrations of cross-sectional side views of microelectronic assemblies with an example glass substrate 110 at various stages in the fabrication of TGVs formed by bottom-up plating with flowable cavity-fill materials in combination with the use of a liner 422, according to some embodiments of the present disclosure.

As shown with a microelectronic assembly 1200A of FIG. 12A, the modified third fabrication method may begin with providing a glass substrate 110 with one or more TGV openings 420 extending between the first face 190-1 and the second face 190-2 of the glass substrate 110 and, possibly, with a cavity 421, as described with reference to FIG. 8A, except that the microelectronic assembly 1200A may not yet include the metal coil 410 and the adhesive 412 at the first face 190-1 of the glass substrate 110.

As shown with a microelectronic assembly 1200B of FIG. 12B, the modified third fabrication method may then proceed with depositing the liner 422 on at least sidewalls 194 of the TGV openings 420 and the cavity 421. Descriptions of the liner 422 provided with reference to the modified first fabrication method are applicable to the modified third fabrication method and, in the interest of brevity, are not repeated.

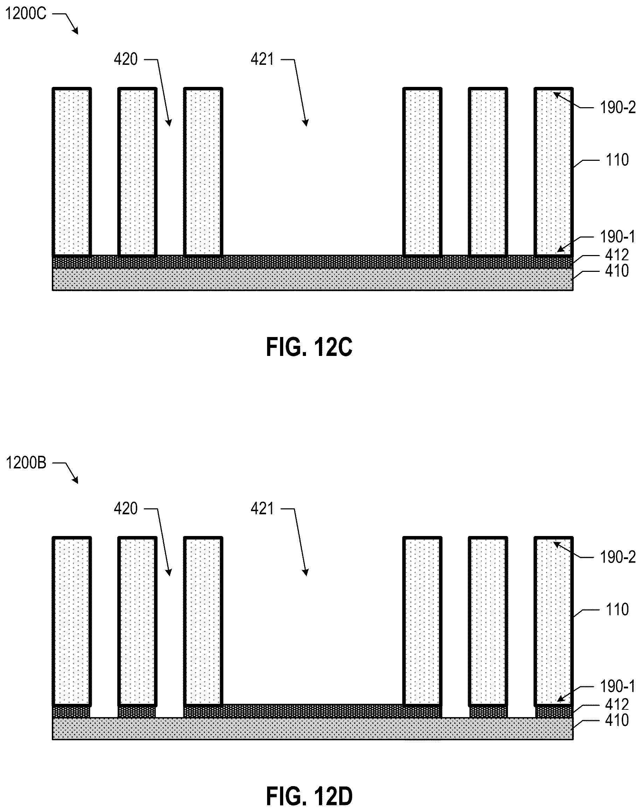

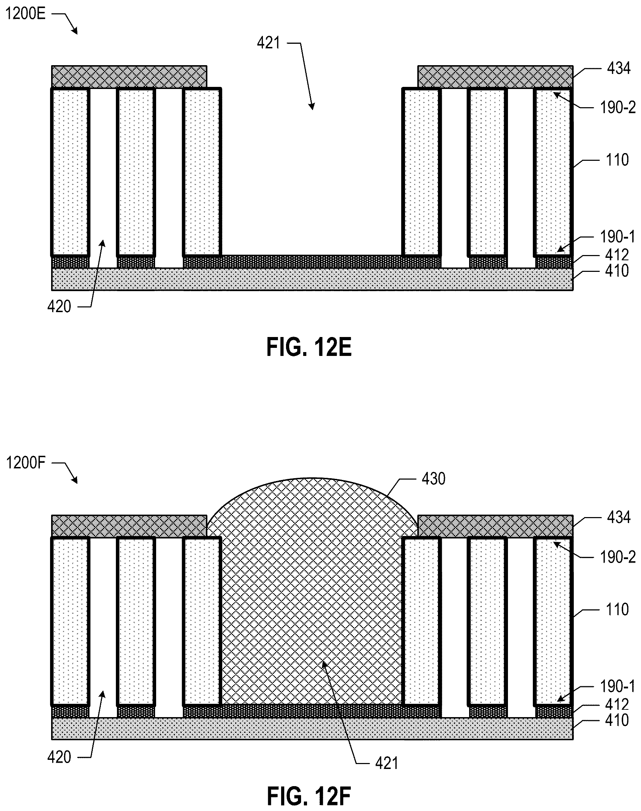

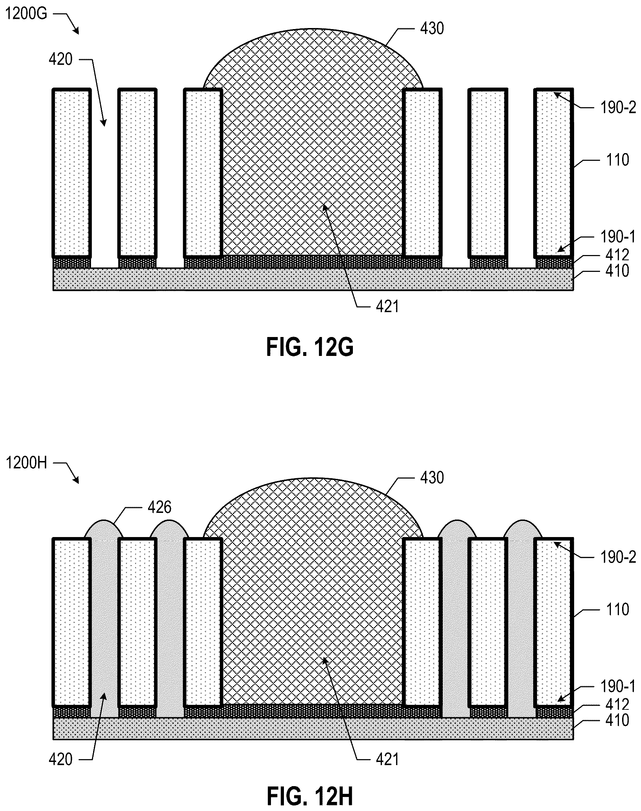

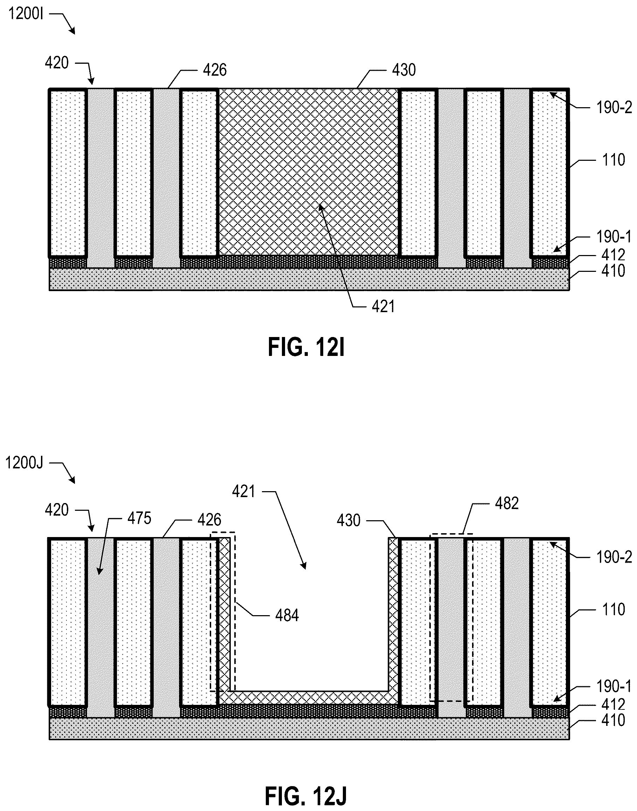

After depositing the liner 422, the modified third fabrication method may then proceed with processes of the third fabrication method as described above but applied to a glass substrate 110 with the liner 422. Thus, FIG. 12C illustrates a microelectronic assembly 1200C which is substantially the same as the microelectronic assembly 800A but with the liner 422, FIG. 12D illustrates a microelectronic assembly 1200D which is substantially the same as the microelectronic assembly 800B but with the liner 422, FIG. 12E illustrates a microelectronic assembly 1200E which is substantially the same as the microelectronic assembly 800C but with the liner 422, FIG. 12F illustrates a microelectronic assembly 1200F which is substantially the same as the microelectronic assembly 800D but with the liner 422, FIG. 12G illustrates a microelectronic assembly 1200G which is substantially the same as the microelectronic assembly 800E but with the liner 422, FIG. 12H illustrates a microelectronic assembly 1200H which is substantially the same as the microelectronic assembly 800F but with the liner 422, FIG. 12I illustrates a microelectronic assembly 1200I which is substantially the same as the microelectronic assembly 800G but with the liner 422, and FIG. 12J illustrates a microelectronic assembly 1200J which is substantially the same as the microelectronic assembly 800H but with the liner 422.

Any of the microelectronic assemblies described with reference to FIGS. 4-12 may be included in any of the microelectronic assemblies 100 described with reference to FIGS. 1-2. For example, any of the microelectronic assemblies described with reference to FIGS. 4-12 may replace the glass substrate 110 of FIGS. 1-2.

Various embodiments of glass substrates having TGVs fabricated using bottom-up plating techniques as described herein may, advantageously, be easily fabricated in parallel with conventional manufacturing techniques for glass substrate substrates. Various arrangements of the microelectronic assemblies 100 and glass substrates 110 as shown in FIGS. 1-12 do not represent an exhaustive set of microelectronic assemblies and glass substrates in which one or more TGVs fabricated using bottom-up plating techniques as described herein may be implemented, but merely provide some illustrative examples. In particular, the number and positions of various elements shown in FIGS. 1-12 is purely illustrative and, in various other embodiments, other numbers of these elements, provided in other locations relative to one another, may be used in accordance with the general architecture considerations described herein. For example, although not specifically shown in the present drawings, in some embodiments, a microelectronic assembly 100 may include a redistribution layer (RDL) between any pair of layers shown in FIG. 1 and FIG. 2, the RDL including a plurality of interconnect structures (e.g., conductive lines and conductive vias) to assist routing of signals and/or power between components. In another example, although also not specifically shown in the present drawings, in some embodiments, a package substrate 102 of a microelectronic assembly 100 may include one or more recesses. In such embodiments, a bottom face of a recess in the package substrate 102 may be provided by the solid material of the package substrate 102. A recess may be formed in a package substrate 102 in any suitable manner (e.g., via three-dimensional printing, laser cutting or drilling the recess into an existing package substrate, etc.). At least a portion of the substrate 107 or the glass substrate 110 may be positioned over or at least partially in such a recess. In yet another example, features of any one of FIGS. 1-12 may be combined with features of any other one of FIGS. 1-12. For example, in some embodiments, some portions of a glass substrate 110 may include one or more TGVs fabricated using the method shown in FIGS. 4A-4F, while other portions of a glass substrate 110 may include one or more TGVs fabricated using the method shown in FIGS. 6A-6K and/or using the method shown in FIGS. 8A-8H.

The microelectronic assemblies 100 and/or the glass substrates 110 disclosed herein, in particular the glass substrates 110 with one or more TGVs fabricated using bottom-up plating techniques as described herein, may be included in any suitable electronic component. FIGS. 13-16 illustrate various examples of apparatuses that may include, or be included in, any of the microelectronic assemblies 100 and/or the glass substrates 110 disclosed herein.

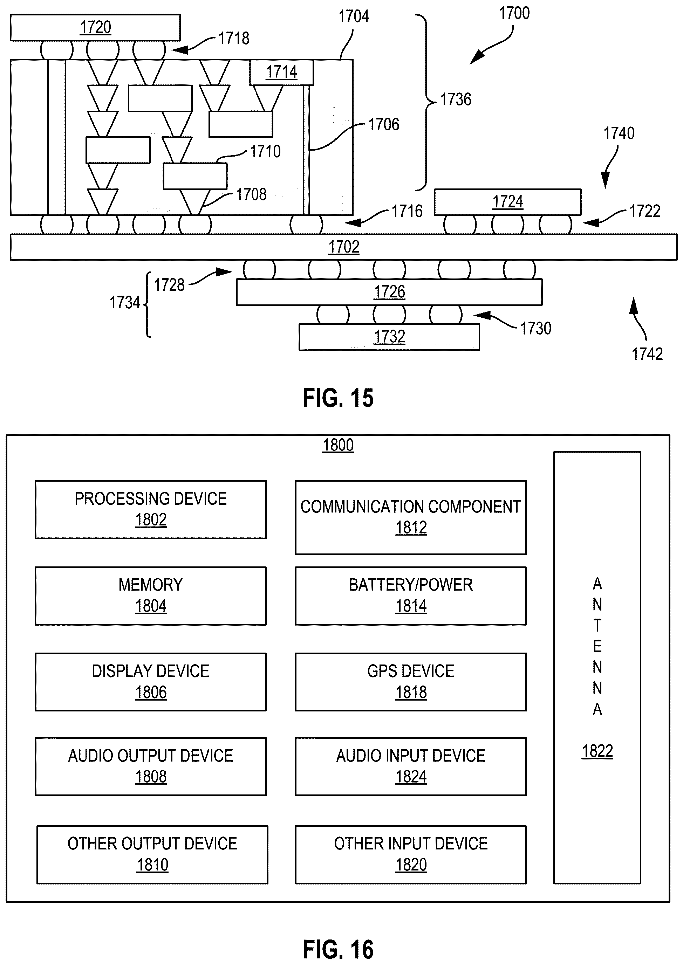

FIG. 13 is a top view of a wafer 1500 and dies 1502 that may be included in any of the microelectronic assemblies 100 as described herein. For example, a die 1502 may be any of the dies 114 described herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more transistors (e.g., some of the transistors 1640 of FIG. 14, discussed below) and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 16) or other logic that is configured to store information in the memory devices or execute instructions stored in the memory array.

FIG. 14 is a side, cross-sectional view of an IC device 1600 that may be included in any of the microelectronic assemblies 100 as described herein. For example, an IC device 1600 may be provided on/in any of the dies 114 described herein. The IC device 1600 may be formed on a substrate 1602 (e.g., the wafer 1500 of FIG. 13) and may be included in a die (e.g., the die 1502 of FIG. 13). The substrate 1602 may be a semiconductor substrate composed of semiconductor material systems including, for example, N-type or P-type materials systems (or a combination of both). The substrate 1602 may include, for example, a crystalline substrate formed using a bulk silicon or a silicon-on-insulator (SOI) substructure. In some embodiments, the substrate 1602 may be formed using alternative materials, which may or may not be combined with silicon, that include but are not limited to germanium, indium antimonide, lead telluride, indium arsenide, indium phosphide, gallium arsenide, or gallium antimonide. Further materials classified as group III-V materials (i.e., materials from groups III and V of the periodic system of elements), group II-VI (i.e., materials from groups II and IV of the periodic system of elements), or group IV materials (i.e., materials from group IV of the periodic system of elements) may also be used to form the substrate 1602. Although a few examples of materials from which the substrate 1602 may be formed are described here, any material that may serve as a foundation for an IC device 1600 may be used. The substrate 1602 may be part of a singulated die (e.g., the dies 1502 of FIG. 13) or a wafer (e.g., the wafer 1500 of FIG. 13).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 14 and may include a wide variety of other types and configurations such as, for example, planar transistors, non-planar transistors, or a combination of both. Planar transistors may include bipolar junction transistors (BJT), heterojunction bipolar transistors (HBT), or high-electron-mobility transistors (HEMT). Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate dielectric and a gate electrode. The gate dielectric may include one layer or a stack of layers. The one or more layers may include silicon oxide, silicon dioxide, silicon carbide, and/or a high-k dielectric material. The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one P-type work function metal or n-type work function metal, depending on whether the transistor 1640 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer. For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 1640 along the source-channel-drain direction, the gate electrode may consist of a U-shaped structure that includes a bottom portion substantially parallel to the surface of the substrate and two sidewall portions that are substantially perpendicular to the top face of the substrate. In other embodiments, at least one of the metal layers that form the gate electrode may simply be a planar layer that is substantially parallel to the top face of the substrate and does not include sidewall portions substantially perpendicular to the top face of the substrate. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 1620 may be formed within the substrate 1602 adjacent to the gate 1622 of each transistor 1640. The S/D regions 1620 may be formed using an implantation/diffusion process or an etching/deposition process, for example. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion-implantation process. In the latter process, the substrate 1602 may first be etched to form recesses at the locations of the S/D regions 1620. An epitaxial deposition process may then be carried out to fill the recesses with material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620.

Electrical signals, such as power and/or input/output (I/O) signals, may be routed to and/or from the devices (e.g., the transistors 1640) of the device layer 1604 through one or more interconnect layers disposed on the device layer 1604 (illustrated in FIG. 14 as interconnect layers 1606, 1608, and 1610). For example, electrically conductive features of the device layer 1604 (e.g., the gate 1622 and the S/D contacts 1624) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 14). Although a particular number of interconnect layers 1606, 1608, and 1610 is depicted in FIG. 14, embodiments of the present disclosure include IC devices having more or fewer interconnect layers than depicted.

In some embodiments, the interconnect structures 1628 may include lines 1628a and/or vias 1628b filled with an electrically conductive material such as a metal. The lines 1628a may be arranged to route electrical signals in the direction of a plane that is substantially parallel with a surface of the substrate 1602 upon which the device layer 1604 is formed. For example, the lines 1628a may route electrical signals in a direction in and out of the page from the perspective of FIG. 14. The vias 1628b may be arranged to route electrical signals in a direction of a plane that is substantially perpendicular to the surface of the substrate 1602 upon which the device layer 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 14. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device layer 1604. In some embodiments, the first interconnect layer 1606 may include lines 1628a and/or vias 1628b, as shown. The lines 1628a of the first interconnect layer 1606 may be coupled with contacts (e.g., the S/D contacts 1624) of the device layer 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device layer 1604) may be thicker.

The IC device 1600 may include a solder resist material 1634 (e.g., polyimide or similar material) and one or more conductive contacts 1636 formed on the interconnect layers 1606, 1608, and 1610. In FIG. 14, the conductive contacts 1636 are illustrated as taking the form of bond pads. The conductive contacts 1636 may be electrically coupled with the interconnect structures 1628 and configured to route the electrical signals of the transistor(s) 1640 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

FIG. 15 is a side, cross-sectional view of an IC device assembly 1700 that may include a glass substrate with one or more TGVs fabricated using bottom-up plating techniques in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the microelectronic assemblies 100 discussed above, e.g., may include one or more microelectronic assemblies 100 as discussed with reference to FIG. 1 and FIG. 2, and/or may include one or more glass substrates as discussed with reference to FIGS. 3-10.

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 15 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 15), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 15, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 5), an IC device (e.g., any of the IC devices described herein, or any combination of such IC devices), or any other suitable component. Generally, the package interposer 1704 may spread a connection to a wider pitch or reroute a connection to a different connection. For example, the package interposer 1704 may couple the IC package 1720 (e.g., a die) to a set of ball grid array (BGA) conductive contacts of the coupling components 1716 for coupling to the circuit board 1702. In the embodiment illustrated in FIG. 15, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a glass substrate with one or more TGVs fabricated using bottom-up plating techniques as described herein, e.g., as any embodiment of the glass substrate 110, described herein. In some embodiments, the package interposer 1704 may be formed as a PCB. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. In any of these embodiments, the package interposer 1704 may include multiple metal layers separated from one another by layers of dielectric material and interconnected by electrically conductive vias. The package interposer 1704 may include metal lines 1710 and vias 1708, including but not limited to conductive vias 1706. If the package interposer 1704 is a glass substrate, e.g., the glass substrate 110 as described herein, then the conductive vias 1706 may be TGVs 115 as described herein, e.g., conductive vias fabricated using bottom-up plating techniques as described herein. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 15 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 16 is a block diagram of an example communication device 1800 that may include one or more microelectronic assemblies 100 and/or one or more glass substrates 110 in accordance with any of the embodiments disclosed herein. A handheld communication device or a laptop communication device may be examples of the communication device 1800. Any suitable ones of the components of the communication device 1800 may include one or more of the microelectronic assemblies 100, IC packages 1720, 1724, IC device assemblies 1700, IC devices 1600, or dies 1502 disclosed herein. In particular, any suitable ones of the components of the communication device 1800 may include one or more glass substrates 110 as described herein, e.g., as a part of a microelectronic assembly 100 as described herein. A number of components are illustrated in FIG. 16 as included in the communication device 1800, but any one or more of these components may be omitted or duplicated, as suitable for the application. In some embodiments, some or all of the components included in the communication device 1800 may be attached to one or more motherboards. In some embodiments, some or all of these components are fabricated onto a single system-on-a-chip (SoC) die.

Additionally, in various embodiments, the communication device 1800 may not include one or more of the components illustrated in FIG. 16, but the communication device 1800 may include interface circuitry for coupling to the one or more components. For example, the communication device 1800 may not include a display device 1806, but may include display device interface circuitry (e.g., a connector and driver circuitry) to which a display device 1806 may be coupled. In another set of examples, the communication device 1800 may not include an audio input device 1824 or an audio output device 1808 but may include audio input or output device interface circuitry (e.g., connectors and supporting circuitry) to which an audio input device 1824 or audio output device 1808 may be coupled.

The communication device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The communication device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded DRAM (eDRAM) or spin transfer torque magnetic RAM (STT-MRAM).

In some embodiments, the communication device 1800 may include a communication module 1812 (e.g., one or more communication modules). For example, the communication module 1812 may be configured for managing wireless communications for the transfer of data to and from the communication device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not. The communication module 1812 may be, or may include, any of the microelectronic assemblies 100 disclosed herein.

The communication module 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication module 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication module 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication module 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication module 1812 may operate in accordance with other wireless protocols in other embodiments. The communication device 1800 may include an antenna 1822 to facilitate wireless communications and/or to receive other wireless communications (such as AM or FM radio transmissions). The antenna 1822 may include one or more microelectronic assemblies 100 and/or one or more glass substrates 110 as described herein, e.g., as a part of a microelectronic assembly 100 as described herein.

In some embodiments, the communication module 1812 may manage wired communications, such as electrical, optical, or any other suitable communication protocols (e.g., the Ethernet). As noted above, the communication module 1812 may include multiple communication modules. For instance, a first communication module 1812 may be dedicated to shorter-range wireless communications such as Wi-Fi or Bluetooth, and a second communication module 1812 may be dedicated to longer-range wireless communications such as global positioning system (GPS), EDGE, GPRS, CDMA, WiMAX, LTE, EV-DO, or others. In some embodiments, a first communication module 1812 may be dedicated to wireless communications, and a second communication module 1812 may be dedicated to wired communications. In some embodiments, the communication module 1812 may support millimeter wave communication.

The communication device 1800 may include battery/power circuitry 1814. The battery/power circuitry 1814 may include one or more energy storage devices (e.g., batteries or capacitors) and/or circuitry for coupling components of the communication device 1800 to an energy source separate from the communication device 1800 (e.g., AC line power).

The communication device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The communication device 1800 may include an audio output device 1808 (or corresponding interface circuitry, as discussed above). The audio output device 1808 may include any device that generates an audible indicator, such as speakers, headsets, or earbuds.

The communication device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The communication device 1800 may include a GPS device 1818 (or corresponding interface circuitry, as discussed above). The GPS device 1818 may be in communication with a satellite-based system and may receive a location of the communication device 1800, as known in the art.

The communication device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The communication device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The communication device 1800 may have any desired form factor, such as a handheld or mobile communication device (e.g., a cell phone, a smart phone, a mobile internet device, a music player, a tablet computer, a laptop computer, a netbook computer, an ultrabook computer, a personal digital assistant (PDA), an ultra-mobile personal computer, etc.), a desktop communication device, a server or other networked computing component, a printer, a scanner, a monitor, a set-top box, an entertainment control unit, a vehicle control unit, a digital camera, a digital video recorder, or a wearable communication device. In some embodiments, the communication device 1800 may be any other electronic device that processes data.

The following paragraphs provide examples of various ones of the embodiments disclosed herein.

Example 1 provides a microelectronic assembly, including a glass substrate (e.g., a glass core or a layer of glass, e.g., a layer of glass including a substantially rectangular prism volume, possibly with rounded or beveled edges) having a first face and a second face opposite the first face; a TGV in the glass substrate, the TGV extending between the first face and the second face and including a conductive material; a first conductive contact to the TGV at the first face of the glass substrate; and a second conductive contact to the TGV at the second face of the glass substrate, in which: a seed material is present between the first conductive contact and a portion of the TGV at the first face of the glass substrate, and the second conductive contact is in contact (e.g., in direct physical contact) with a portion of the TGV at the second face of the glass substrate (i.e., there is no seed material present between the conductive contact and the TGV at the second face of the glass substrate).

Example 2 provides the microelectronic assembly according to example 1, further including a void between the conductive material and a portion of a sidewall of the TGV.

Example 3 provides the microelectronic assembly according to example 2, in which a width of the void is between about 20 nanometers and about 200 nanometers, e.g., between about 40 nanometers and about 140 nanometers.

Example 4 provides the microelectronic assembly according to examples 2 or 3, in which the void is one of a plurality of voids between the conductive material and different portions of the sidewall of the TGV.

Example 5 provides the microelectronic assembly according to any one of the preceding examples, further including a liner material in the TGV, between the conductive material and the glass substrate.

Example 6 provides the microelectronic assembly according to example 5, in which the liner material is in contact (e.g., in direct physical contact) with a sidewall of the TGV.

Example 7 provides the microelectronic assembly according to example 6, further including a void between the conductive material and the liner material at a portion of the sidewall of the TGV.

Example 8 provides the microelectronic assembly according to example 7, in which a width of the void is between about 20 nanometers and about 200 nanometers, e.g., between about 40 nanometers and about 140 nanometers.

Example 9 provides the microelectronic assembly according to examples 7 or 8, in which the void is one of a plurality of voids between the conductive material and the liner material at different portions of the sidewall of the TGV.

Example 10 provides the microelectronic assembly according to any one of examples 5-9, in which a thickness of the liner material is between about 200 nanometers and about 10 microns, e.g., between about 200 nanometers and about 5 microns, or between about 500 nanometers and about 1 micron.

Example 11 provides the microelectronic assembly according to any one of examples 5-10, in which a modulus (e.g., a Young's modulus) of the liner material is smaller than about 30 gigapascal (GPa), e.g., between about 1 GPa and 30 GPa, or between about 1 GPa and 20 GPa, or between about 1 GPa and 15 GPa.

Example 12 provides the microelectronic assembly according to any one of examples 5-11, in which a CTE of the liner material is smaller than a CTE of the conductive material.

Example 13 provides the microelectronic assembly according to any one of examples 5-12, in which the liner material includes/is a polymer material.

Example 14 provides the microelectronic assembly according to examples any one of claims 5-13, in which the liner material includes/is a homopolymer.

Example 15 provides the microelectronic assembly according to any one of examples 5-14, in which the liner material includes/is poly-para-xylylene.

Example 16 provides the microelectronic assembly according to any one of examples 5-13, in which the liner material includes/is a heteropolymer.

Example 17 provides the microelectronic assembly according to any one of examples 5-13 or 16, in which the liner material includes/is at least one of polyester (PET), polyurethane (PU), polycarbonate (PC), polyvinyl chloride (PVC), or polybenzoxazole (PBO).

Example 18 provides the microelectronic assembly according to any one of examples 5-12, in which the liner material includes/is a non-polymer material.

Example 19 provides the microelectronic assembly according to any one of examples 5-12 or 18, in which the liner material includes/is an inorganic non-polymer material.

Example 20 provides the microelectronic assembly according to any one of examples 5-19, in which the liner material includes two or more layers of materials having different material compositions.

Example 21 provides the microelectronic assembly according to any one of the preceding examples, in which a grain structure of the seed material is different from a grain structure of the conductive material.

Example 22 provides the microelectronic assembly according to any one of the preceding examples, in which an average grain size of the seed material is different from an average grain size of the conductive material.

Example 23 provides the microelectronic assembly according to any one of the preceding examples, in which an average grain size of the seed material is smaller than an average grain size of the conductive material.

Example 24 provides the microelectronic assembly according to any one of the preceding examples, in which an average grain orientation of the seed material is different from an average grain orientation of the conductive material.

Example 25 provides the microelectronic assembly according to any one of the preceding examples, further including a grain boundary between the seed material and the conductive material.

Example 26 provides the microelectronic assembly according to any one of the preceding examples, in which no seed material is present between the second conductive contact and the portion of the TGV at the second face of the glass substrate.

Example 27 provides the microelectronic assembly according to any one of examples 1-26, further including a further material between the seed material and the first face of the glass substrate.

Example 28 provides the microelectronic assembly according to example 27, in which the further material includes titanium.

Example 29 provides the microelectronic assembly according to examples 27 or 28, in which the further material is further between the seed material and the conductive material.

Example 30 provides the microelectronic assembly according to any one of examples 1-29, in which the seed material has a first face and a second face opposite the first face, the first face of the seed material is in contact (e.g., in direct physical contact) with the first conductive contact, and the second face of the seed material is in contact (e.g., in direct physical contact) with the portion of the TGV at the first face of the glass substrate.

Example 31 provides a microelectronic assembly, including a glass substrate having a first face and a second face opposite the first face; a TGV in the glass substrate, the TGV extending between the first face and the second face and including a conductive material; a first conductive contact to the TGV at the first face of the glass substrate; and a second conductive contact to the TGV at the second face of the glass substrate, in which: a material composition of the first conductive contact is different from a material composition of the conductive material, and a material composition of the second conductive contact and the material composition of the conductive material are substantially same.

Example 32 provides the microelectronic assembly according to example 31, further including a void between the conductive material and a portion of a sidewall of the TGV.

Example 33 provides the microelectronic assembly according to example 32, in which a width of the void is between about 20 nanometers and about 200 nanometers, e.g., between about 40 nanometers and about 140 nanometers.

Example 34 provides the microelectronic assembly according to examples 32 or 33, in which the void is one of a plurality of voids between the conductive material and different portions of the sidewall of the TGV.

Example 35 provides the microelectronic assembly according to any one of examples 31-34, further including a liner material in the TGV, between the conductive material and the glass substrate.

Example 36 provides the microelectronic assembly according to example 35, in which the liner material is in contact (e.g., in direct physical contact) with a sidewall of the TGV.

Example 37 provides the microelectronic assembly according to example 36, further including a void between the conductive material and the liner material at a portion of the sidewall of the TGV.

Example 38 provides the microelectronic assembly according to example 37, in which a width of the void is between about 20 nanometers and about 200 nanometers, e.g., between about 40 nanometers and about 140 nanometers.

Example 39 provides the microelectronic assembly according to examples 37 or 38, in which the void is one of a plurality of voids between the conductive material and the liner material at different portions of the sidewall of the TGV.

Example 40 provides the microelectronic assembly according to any one of examples 35-39, in which a thickness of the liner material is between about 200 nanometers and about 10 microns, e.g., between about 200 nanometers and about 5 microns, or between about 500 nanometers and about 1 micron.

Example 41 provides the microelectronic assembly according to any one of examples 35-40, in which a modulus (e.g., a Young's modulus) of the liner material is smaller than about 30 gigapascal (GPa), e.g., between about 1 GPa and 30 GPa, or between about 1 GPa and 20 GPa, or between about 1 GPa and 15 GPa.

Example 42 provides the microelectronic assembly according to any one of examples 35-41, in which a CTE of the liner material is smaller than a CTE of the conductive material.

Example 43 provides the microelectronic assembly according to any one of examples 35-42, in which the liner material includes/is a polymer material.

Example 44 provides the microelectronic assembly according to examples any one of claims 35-43, in which the liner material includes/is a homopolymer.

Example 45 provides the microelectronic assembly according to any one of examples 35-44, in which the liner material includes/is poly-para-xylylene.

Example 46 provides the microelectronic assembly according to any one of examples 35-43, in which the liner material includes/is a heteropolymer.

Example 47 provides the microelectronic assembly according to any one of examples 35-43 or 46, in which the liner material includes/is at least one of polyester (PET), polyurethane (PU), polycarbonate (PC), polyvinyl chloride (PVC), or polybenzoxazole (PBO).

Example 48 provides the microelectronic assembly according to any one of examples 35-42, in which the liner material includes/is a non-polymer material.

Example 49 provides the microelectronic assembly according to any one of examples 35-42 or 48, in which the liner material includes/is an inorganic non-polymer material.

Example 50 provides the microelectronic assembly according to any one of examples 35-49, in which the liner material includes two or more layers of materials having different material compositions.

Example 51 provides the microelectronic assembly according to any one of examples 31-50, in which a further material is attached to the first face of the glass substrate, and the further material is absent between the first conductive contact and the conductive material.

Example 52 provides the microelectronic assembly according to example 51, in which a portion of the further material is between the first conductive contact and the first face of the glass substrate.

Example 53 provides the microelectronic assembly according to any one of examples 31-53, in which a seed material is absent from the first face of the glass substrate, the second face of the glass substrate, and sidewalls of the TGV.

Example 54 provides the microelectronic assembly according to any one of examples 31-53, in which an angle between a sidewall of the first conductive contact and the first face of the glass substrate is less than about 85 degrees.

Example 55 provides the microelectronic assembly according to any one of examples 31-54, in which an angle between a sidewall of the second conductive contact and the second face of the glass substrate is less than about 85 degrees.

Example 56 provides the microelectronic assembly according to any one of examples 31-55, in which no grain boundary is present between the second conductive contact and the conductive material.

Example 57 provides the microelectronic assembly according to any one of examples 31-56, in which a width of the first conductive contact tapers in a direction away from the first face of the glass substrate.

Example 58 provides the microelectronic assembly according to any one of examples 31-57, in which a width of the second conductive contact tapers in a direction away from the first face of the glass substrate.

Example 59 provides the microelectronic assembly according to any one of examples 31-58, in which a sidewall of the first conductive contact has a concave portion.

Example 60 provides the microelectronic assembly according to any one of examples 31-59, in which a sidewall of the second conductive contact has a concave portion.

Example 61 provides a microelectronic assembly, including a glass substrate having a first face and a second face opposite the first face; a TGV in the glass substrate, the TGV extending between the first face and the second face and including a liner material and a conductive material, in which the liner material is between the conductive material and the glass substrate; a first conductive contact to the TGV at the first face of the glass substrate; and a second conductive contact to the TGV at the second face of the glass substrate, in which a modulus (e.g., a Young's modulus) of the liner material is smaller than about 30 gigapascal (GPa), e.g., between about 1 GPa and 30 GPa, or between about 1 GPa and 20 GPa, or between about 1 GPa and 15 GPa.

Example 62 provides the microelectronic assembly according to example 61, further including a void between the conductive material and a portion of a sidewall of the TGV.

Example 63 provides the microelectronic assembly according to example 62, in which a width of the void is between about 20 nanometers and about 200 nanometers, e.g., between about 40 nanometers and about 140 nanometers.

Example 64 provides the microelectronic assembly according to examples 62 or 63, in which the void is one of a plurality of voids between the conductive material and different portions of the sidewall of the TGV.

Example 65 provides the microelectronic assembly according to any one of examples 61-44, in which the liner material includes/is poly-para-xylylene.

Example 66 provides the microelectronic assembly according to any one of examples 61-65, in which the liner material includes/is parylene N, parylene C, parylene D, or halogen free poly-para-xylylene.

Example 67 provides the microelectronic assembly according to any one of examples 61-66, in which the liner material is in contact (e.g., in direct physical contact) with a sidewall of the TGV.

Example 68 provides the microelectronic assembly according to example 67, further including a void between the conductive material and the liner material at a portion of the sidewall of the TGV.

Example 69 provides the microelectronic assembly according to example 68, in which a width of the void is between about 20 nanometers and about 200 nanometers, e.g., between about 40 nanometers and about 140 nanometers.

Example 70 provides the microelectronic assembly according to any one of examples 61-69, in which: a material composition of the first conductive contact is different from a material composition of the conductive material, and a material composition of the second conductive contact and the material composition of the conductive material are substantially same.

Example 71 provides a microelectronic assembly, including a glass substrate having a first face and a second face opposite the first face; a TGV in the glass substrate, the TGV extending between the first face and the second face and including a conductive material; a cavity in the glass substrate, the cavity extending from the first face towards the second face; and a material on a sidewall of the cavity, in which a total volume of glass filler particles in the material is less than about 15% of a total volume of the material on the sidewall of the cavity.

Example 72 provides the microelectronic assembly according to example 71, further including a void between the conductive material and a portion of a sidewall of the TGV.

Example 73 provides the microelectronic assembly according to example 72, in which a width of the void is between about 20 nanometers and about 200 nanometers, e.g. between about 40 nanometers and about 140 nanometers.

Example 74 provides the microelectronic assembly according to examples 72 or 73, in which the void is one of a plurality of voids between the conductive material and different portions of the sidewall of the TGV.

Example 75 provides the microelectronic assembly according to any one of examples 71-74, further including a liner material in the TGV, between the conductive material and the glass substrate.

Example 76 provides the microelectronic assembly according to example 75, in which the liner material is in contact (e.g., in direct physical contact) with a sidewall of the TGV.

Example 77 provides the microelectronic assembly according to example 76, further including a void between the conductive material and the liner material at a portion of the sidewall of the TGV.

Example 78 provides the microelectronic assembly according to example 77, in which a width of the void is between about 20 nanometers and about 200 nanometers, e.g., between about 40 nanometers and about 140 nanometers.

Example 79 provides the microelectronic assembly according to examples 77 or 78, in which the void is one of a plurality of voids between the conductive material and the liner material at different portions of the sidewall of the TGV.

Example 80 provides the microelectronic assembly according to any one of examples 75-79, in which a thickness of the liner material is between about 200 nanometers and about 10 microns, e.g., between about 200 nanometers and about 5 microns, or between about 500 nanometers and about 1 micron.

Example 81 provides the microelectronic assembly according to any one of examples 75-80, in which a modulus (e.g., a Young's modulus) of the liner material is smaller than about 30 gigapascal (GPa), e.g., between about 1 GPa and 30 GPa, or between about 1 GPa and 20 GPa, or between about 1 GPa and 15 GPa.

Example 82 provides the microelectronic assembly according to any one of examples 75-81, in which a CTE of the liner material is smaller than a CTE of the conductive material.

Example 83 provides the microelectronic assembly according to any one of examples 75-82, in which the liner material includes/is a polymer material.

Example 84 provides the microelectronic assembly according to examples any one of claims 75-83, in which the liner material includes/is a homopolymer.

Example 85 provides the microelectronic assembly according to any one of examples 75-84, in which the liner material includes/is poly-para-xylylene.

Example 86 provides the microelectronic assembly according to any one of examples 75-83, in which the liner material includes/is a heteropolymer.

Example 87 provides the microelectronic assembly according to any one of examples 75-83 or 86, in which the liner material includes/is at least one of polyester (PET), polyurethane (PU), polycarbonate (PC), polyvinyl chloride (PVC), or polybenzoxazole (PBO).

Example 88 provides the microelectronic assembly according to any one of examples 75-82, in which the liner material includes/is a non-polymer material.

Example 89 provides the microelectronic assembly according to any one of examples 75-82 or 88, in which the liner material includes/is an inorganic non-polymer material.

Example 90 provides the microelectronic assembly according to any one of examples 75-89, in which the liner material includes two or more layers of materials having different material compositions.

Example 91 provides the microelectronic assembly according to any one of examples 71-90, in which the material includes/is a polymer material.

Example 92 provides the microelectronic assembly according to any one of examples 71-91, in which the material includes/is an epoxy.

Example 93 provides the microelectronic assembly according to any one of examples 71-92, in which a thickness of the material on the sidewall of the cavity is between about 10 microns and about 2-3 mm.

Example 94 provides the microelectronic assembly according to any one of examples 71-93, in which the conductive material and the material are coplanar at the first face of the glass substrate.

Example 95 provides the microelectronic assembly according to any one of examples 71-94, in which the conductive material and the material are coplanar at the second face of the glass substrate.

Example 96 provides the microelectronic assembly according to any one of the preceding examples, in which a cross-section of the glass substrate in a plane perpendicular to a surface of the component is substantially rectangular.

Example 97 provides the microelectronic assembly according to any one of the preceding examples, in which a cross-section of the glass substrate in a plane parallel to a surface of the component is substantially rectangular.

Example 98 provides the microelectronic assembly according to any one of the preceding examples, in which the glass substrate is a solid layer of glass.

Example 99 provides the microelectronic assembly according to any one of the preceding examples, in which the glass substrate is a layer of glass including at least 23% silicon by weight.

Example 100 provides the microelectronic assembly according to any one of the preceding examples, in which the glass substrate is a layer of glass including at least 26% oxygen by weight.

Example 101 provides the microelectronic assembly according to any one of the preceding examples, in which the glass substrate is a layer of glass including at least 23% silicon by weight and at least 26% oxygen by weight.

Example 102 provides the microelectronic assembly according to any one of the preceding examples, in which the glass substrate is a layer of glass including at least 5% aluminum by weight.

Example 103 provides the microelectronic assembly according to any one of the preceding examples, in which the glass substrate is a layer of glass that does not include an organic adhesive or an organic material.

Example 104 provides the microelectronic assembly according to any one of the preceding examples, in which the glass substrate is a layer of glass having a thickness in a range of 50 micron (um) to 1.4 millimeters (mm), a first length in a range of 10 mm to 250 mm, and a second length in a range of 10 mm to 250 mm, the first length perpendicular to the second length.

Example 105 provides the microelectronic assembly according to any one of the preceding examples, in which the glass substrate is a layer of glass having a thickness in a range of 50 um to 1.4 mm.

Example 106 provides the microelectronic assembly according to any one of the preceding examples, in which the glass substrate is a layer of glass having a first length in a range of 10 mm to 250 mm, and a second length in a range of 10 mm to 250 mm, the first length perpendicular to the second length.

Example 107 provides the microelectronic assembly according to any one of the preceding examples, in which the glass substrate is a layer of glass including a rectangular prism volume.

Example 108 provides the microelectronic assembly according to any one of the preceding examples, in which the glass substrate is a layer of glass including a rectangular prism volume having a first side and a second side substantially perpendicular to the first side, and in which the first side has a length in a range of 10 mm to 250 mm.

Example 109 provides the microelectronic assembly according to example 108, in which the second side has a length in a range of 10 mm to 250 mm.

Example 110 provides a package, comprising: a glass substrate having a first face and a second face opposite the first face; a through-glass via (TGV) in the glass substrate, the TGV extending between the first face and the second face and comprising a conductive material; a first conductive contact to the TGV at the first face of the glass substrate; and a second conductive contact to the TGV at the second face of the glass substrate, wherein: a material composition of the first conductive contact is different from a material composition of the conductive material, and a material composition of the second conductive contact and the material composition of the conductive material are substantially same.

Example 111 provides the package according to example 110, further comprising: a liner material in the TGV, between the conductive material and the glass substrate; and a void between the conductive material and the liner material at a portion of a sidewall of the TGV, wherein a width of the void is between about 20 nanometers and about 200 nanometers.

Example 112 provides the package according to example 111, wherein a modulus of the liner material is smaller than about 15 gigapascal.

Example 113 provides the package according to any one of examples 110 to 112, wherein a further material is attached to the first face of the glass substrate, and the further material is absent between the first conductive contact and the conductive material.

Example 114 provides the package according to any one of examples 110 to 113, wherein a seed material is absent from the first face of the glass substrate, the second face of the glass substrate, and sidewalls of the TGV.

Example 115 provides the package according to any one of examples 110 to 114, wherein an angle between a sidewall of the first conductive contact and the first face of the glass substrate is less than about 85 degrees.

Example 116 provides the package according to any one of examples 110 to 115, wherein a sidewall of the first conductive contact has a concave portion.

Example 117 provides a semiconductor package, comprising: a glass substrate having a first face and a second face opposite the first face; a through-glass via (TGV) in the glass substrate, the TGV extending between the first face and the second face and comprising a liner material and a conductive material, wherein the liner material is between the conductive material and the glass substrate; a first conductive contact to the TGV at the first face of the glass substrate; and a second conductive contact to the TGV at the second face of the glass substrate, wherein a modulus of the liner material is smaller than about 30 gigapascal.

Example 118 provides the semiconductor package according to example 117, wherein the liner material includes/is parylene N, parylene C, parylene D, or halogen free poly-para-xylylene.

Example 119 provides the semiconductor package according to example 117 or example 118, wherein: a material composition of the first conductive contact is different from a material composition of the conductive material, and a material composition of the second conductive contact and the material composition of the conductive material are substantially same.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. A microelectronic assembly, comprising:
a glass substrate having a first face and a second face opposite the first face;
a through-glass via (TGV) in the glass substrate, the TGV extending between the first face and the second face and comprising a conductive material;
a first conductive contact to the TGV at the first face of the glass substrate; and
a second conductive contact to the TGV at the second face of the glass substrate,
wherein:
a seed material is present between the first conductive contact and a portion of the TGV at the first face of the glass substrate, and
the second conductive contact is in contact with a portion of the TGV at the second face of the glass substrate.

2. The microelectronic assembly according to claim 1, further comprising:
a void between the conductive material and a portion of a sidewall of the TGV.

3. The microelectronic assembly according to claim 2, wherein a width of the void is between about 20 nanometers and about 200 nanometers.

4. The microelectronic assembly according to claims 2 or 3, wherein the void is one of a plurality of voids between the conductive material and different portions of the sidewall of the TGV.

5. The microelectronic assembly according to any one of the preceding claims, further comprising:
a liner material in the TGV, between the conductive material and the glass substrate.

6. The microelectronic assembly according to claim 5, wherein the liner material is in contact with a sidewall of the TGV.

7. The microelectronic assembly according to claims 5 or 6, further comprising:
a void between the conductive material and the liner material at a portion of the sidewall of the TGV.

8. The microelectronic assembly according to claim 7, wherein a width of the void is between about 20 nanometers and about 200 nanometers.

9. The microelectronic assembly according to claims 7 or 8, wherein the void is one of a plurality of voids between the conductive material and the liner material at different portions of the sidewall of the TGV.

10. The microelectronic assembly according to any one of claims 5-9, wherein a thickness of the liner material is between about 200 nanometers and about 10 microns.

11. The microelectronic assembly according to any one of claims 5-10, wherein a modulus of the liner material is smaller than about 30 gigapascal.

12. The microelectronic assembly according to any one of claims 5-11, wherein a coefficient of thermal expansion (CTE) of the liner material is smaller than a CTE of the conductive material.

13. The microelectronic assembly according to any one of claims 5-12, wherein the liner material includes/is poly-para-xylylene.

14. The microelectronic assembly according to any one of the preceding claims, wherein an average grain size of the seed material is smaller than an average grain size of the conductive material.

15. The microelectronic assembly according to any one of the preceding claims, further comprising:
a further material between the seed material and the first face of the glass substrate, wherein the further material includes titanium.
